(19) Europäisches Patentamt
European Patent Office
Office européen des brevets

(11) **EP 4 625 816 A1**

(12) **EUROPEAN PATENT APPLICATION**

(43) Date of publication:
**01.10.2025 Bulletin 2025/40**

(21) Application number: **24166897.9**

(22) Date of filing: **27.03.2024**

(51) International Patent Classification (IPC):
**H03F 7/00** *(2006.01)* **H03F 19/00** *(2006.01)*

(52) Cooperative Patent Classification (CPC):
**H03F 7/00; H03F 19/00;** H10N 69/00

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ETH Zurich**
**8092 Zurich (CH)**

(72) Inventors:
• **WALLRAFF, Andreas**
  **8044 Zürich (CH)**
• **KRINNER, Sebastian**
  **8820 Wädenswil (CH)**
• **HERRMANN, Johannes**
  **8047 Zürich (CH)**
• **GARCIA BELLES, Raquel**
  **8049 Zürich (CH)**

(54) **TRAVELING WAVE PARAMETRIC AMPLIFIER AND MANUFACTURING METHOD, A METHOD FOR AMPLIFYING A TARGET SIGNAL, COMPUTER PROGRAM AND COMPUTER-READABLE DATA CARRIER**

(57)    The invention relates to a traveling wave parametric amplifier (TWPA) for amplifying a target signal. The TWPA comprises a nonlinear transmission line (T1, T2) for receiving and propagating the target signal. The TWPA also comprises a plurality of coupling elements (DC1, DC2), wherein the plurality of coupling elements (DC1, DC2) are arranged at a distance from one another along the nonlinear transmission line (T1, T2). Each coupling element of the plurality of coupling elements (DC1, DC2) is configured to couple a pump signal portion from a pump feed line (D1) into the nonlinear transmission line (T1, T2), wherein the coupled-in pump signal portions form a total pump signal co-propagating in the nonlinear transmission line (T1, T2) in the same direction as the target signal for amplifying the target signal.

Figure 1

**Description**

**Technical field**

The invention relates to a traveling wave parametric amplifier, a method for manufacturing the same, a method for amplifying a target signal, a computer program and a computer readable data carrier.

**Background**

Traveling wave parametric amplifiers (TWPAs) can be used in photonic and quantum technologies, e.g., for frequency-multiplexed readout of superconducting qubits as well as in radio and infrared astronomy, e.g. for the readout of microwave kinetic inductance detectors (MKIDs).

Typically, a TWPA consists of a nonlinear medium which provides a nonlinear mixing process used to amplify an incident target signal, a strong pump tone from which power is converted into signal and idler tones, and a phase matching concept ensuring that signal, idler and pump tones stay approximately synchronized during the amplification process.

TWPAs can be categorized depending on the mixing process (e.g., four-wave mixing vs. three-wave mixing), the nonlinear medium (e.g., Josephson junctions vs. kinetic inductance materials), and the type of phase matching employed (e.g., resonant phase matching, periodic modulation of transmission line parameters, sign-reversal of the Kerr nonlinear coefficient).

Three-wave mixing (3WM) devices, in which single pump photons are converted in signal and idler photons, can have a higher complexity than four-wave mixing (4WM) devices, in which two pump photons at a time are converted in a signal and idler photon. This is because creating a three-wave mixing nonlinearity typically requires additional DC bias currents, or additional flux-biased circuit elements. On the other hand, an advantage of three-wave mixing devices can be that the pump tone is well separated from the signal and idler tones allowing for more direct filtering of the pump tone.

Josephson junctions as compared to kinetic inductance materials can offer a larger nonlinearity and thus efficiency, while kinetic inductance materials may offer a larger saturation power.

Phase matching is typically achieved using dispersion engineering: The dispersion relation of the pump is changed with respective to the one of signal and idler by engineering a stop band close to the pump frequency using either additional periodic filter circuits (resonant phase matching) or a continuous modulation of the inherent transmission line parameters, e.g., related to the strength of the Kerr interaction mediated by the nonlinearity. Here, it is important that the impedance of the transmission line is modulated to create the stop band, so that the dispersion relation becomes nonlinear close to the stop band. However, a stopband limits the frequency-range in which a TWPA is applicable.

Depending on the desired application a readout device may also include comparably complex and expensive components that can be difficult to fabricate and control such as cryogenic and room-temperature low-noise amplifiers as well as elaborate resource-intense control electronics, e.g., for the generation of the pump signal, bias currents or the detection of the readout signals. In particular, if target signals with multiple or varying frequencies have to be detected, the control and measurement circuitry can get very complex.

Therefore, it is desirable to employ multiplexing on the readout side, i.e. to have an amplifier with a sufficiently large bandwidth to enable frequency-multiplexed readout. However, increasing the bandwidth by conventional dispersion engineering can have the downside of creating a stopband in the middle of the gain profile and, in the case of resonant phase matching, of requiring many, potentially large-footprint, resonator circuits. Continuous and periodic modulation techniques on the other hand may suffer from a power-dependence of the dispersion relation, which renders the tune-up more tedious, e.g., for Josephson-Junction-based devices. Some techniques may also result in a non-uniform gain profile which limits the applicability and tunability in certain wavelength regimes.

Thus, an object of the invention is to overcome such limitations and provide a traveling wave parametric amplifier, a method for manufacturing the same, a method for amplifying a target signal, a computer program and a computer readable data carrier that improve upon the available systems and methods for amplification.

**Summary**

This object of the invention is achieved by a traveling wave parametric amplifier, a method for manufacturing the same, a method for amplifying a target signal, a computer program and a computer readable data carrier as described in the appended independent claims. Advantageous developments and embodiments are described in the dependent claims.

The invention relates to a traveling wave parametric amplifier for amplifying a target signal. The traveling wave parametric amplifier comprises a nonlinear transmission line for receiving and propagating the target signal. The traveling wave parametric amplifier also comprises a plurality of coupling elements, wherein the coupling elements are arranged at a distance from one another along the nonlinear transmission line. Each coupling element of the plurality of coupling elements is configured to couple a pump signal portion from a pump feed line into the nonlinear transmission line. The coupled-in pump signal portions form a total pump signal co-propagating in the nonlinear transmission line in the same direction as the target signal for amplifying the target signal. The nonlinear transmission line and the plurality of coupling elements are further configured to bring the coupled-in pump signal portions into interference with respect to each other along the nonlinear transmission line. Through the interference of the coupled-in pump signal portions a phase mismatch between the total pump signal, the target signal and its idler accumulated while co-propagating in the nonlinear transmission line is being compensated at least partially or approximately.

The invention provides a dispersion-less discrete phase matching technology in which the phase of the total pump signal can be interferometrically adjusted only a few times along the non-linear transmission line, achieving high gain in a broad frequency regime without requiring a stopband. This allows for a reliable amplification also of target signals with multiple tones/frequencies, therefore enabling accurate frequency-multiplexed amplification and readout.

The total pump signal used for amplifying the target signal may correspond to a superposition of the coupled-in pump signal portions and may comprise all the coupled-in pump signal portions. At each coupling element another coupled-in pump signal portion may be added to (superposed with) the total pump signal already present and propagating in the nonlinear transmission line. In particular, by coupling the pump signal portions into the nonlinear transmission line via (a few) different coupling elements arranged along the nonlinear transmission line and spaced apart from one another, a coupled-in pump signal portion may interfere with another coupled-in pump signal portion and/or the total pump signal already present in the nonlinear transmission line and having already propagated (and coming from) a finite distance/segment along the nonlinear transmission line, the interference resulting in a total pump signal with adjusted phase. In the following, the phase adjustment process is explained in further detail.

It is noted that the term "signal" according to the present invention refers generally to electromagnetic radiation, e.g., in a pulsed or continuous-wave regime. Optionally, the target signal, the (coupled-in) pump signal portions, the total pump signal and/or the pump tone may be electromagnetic radiation in the microwave or few GHz regime. Alternatively, these signals may also correspond to electromagnetic radiation in another spectral range, e.g., in the optical or THz range. Accordingly, the invention is applicable and practicable in a wide range of the electromagnetic spectrum. Also note, that an electrical length may refer to an electrical length at the pump frequency or at the target signal frequency. Also, in the following the term "segment" is interchangeably used with the term "section".

The plurality of coupling elements may comprise a first coupling element and a second coupling element. The first and the second coupling element may be connected by a first segment of the nonlinear transmission line. The first coupling element may be configured to couple a first pump signal portion into the nonlinear transmission line at the position of the first coupling element. The coupled-in first pump signal portion may propagate along the first segment towards the second coupling element. When propagating along the first segment, the coupled-in first pump signal portion may correspond to the total pump signal at least along the first segment. The total pump signal may co-propagate along the first segment with the target signal and its idler. During co-propagating along the first segment the target signal may be amplified through the nonlinearity of the first segment, the nonlinearity mediating a (e.g., three-wave or four-wave) mixing process between the total pump signal, the target signal and a corresponding idler signal. While co-propagating along the first segment, the target signal, the idler signal and the total pump signal may develop a phase mismatch that may increase with the distance of co-propagation along the nonlinear transmission line. The phase mismatch may be caused by a wavevector mismatch. The wavevector mismatch may comprise a chromatic contribution and/or a Kerr contribution originating from the nonlinearity in the nonlinear transmission line (i.e., the gain medium).

The second coupling element may be configured to couple a second pump signal portion into the nonlinear transmission line at the position of the second coupling element. The position of the second coupling element may correspond to a first interference point. At the first interference point the coupled-in first pump signal portion, i.e., the total pump signal, coming from the first segment, may interfere with the coupled-in second pump signal portion, thereby adjusting the phase of the total pump signal. The interference/superposition signal comprising the coupled-in first pump signal portion coming from the first segment (i.e., the total pump signal from the first segment) and the coupled-in second pump signal may correspond to the (new) total pump signal co-propagating with the target signal and its idler along a second segment of the nonlinear transmission line and amplifying the target signal. The second segment may be arranged after the first segment in propagation direction of the target signal. The starting point of the second segment may be a position of the second coupling element or the first interference point.

Preferably, the phase of the coupled-in first pump signal portion at the first coupling element, the phase of the coupled-in second pump signal portion at the second coupling element, their phase difference, an electrical length of the first segment and/or the length of the first segment is/are configured to adjust the phase of the total pump signal at the first interference point such that the phase mismatch accumulated between the total pump signal, the target signal and its idler along the first segment is being compensated at least partially or approximately. The phase mismatch may be compensated fully at the first interference point (within measurement accuracy).

The adjustment of the phase at the first interference point may correspond to a jump of the phase of the total pump signal at the first interference point. The jump can lead to a step-like increase of the phase of the total pump signal as a function of the length of the nonlinear transmission line. The jump and/or step-like behavior of the phase of the total pump signal may occur on top of a dynamic phase and a Kerr phase. A step width may correspond to the length of the first segment. The step height, the step width and the wavevector mismatch may fulfill a phase matching condition e.g., derived from a theoretical model. The theoretical model may include a model of the wavevector mismatch along the nonlinear transmission line. The configuration of the phase of the coupled-in second pump signal portion, the phase of the coupled-in first pump signal portion, their phase difference, an electrical length and/or the length of the first segment may be based on the theoretical model.

The first coupling element and the second coupling element may also be connected by a first segment of the pump feed line. The first segment of the pump feed line and the first segment of the nonlinear transmission line may be spaced apart from each other and/or may have different lengths (and/or different electrical lengths, e.g., at the pump frequency or at the target signal frequency). The pump frequency of the coupled-in first pump signal portion, the pump frequency of the coupled-in second pump signal portion and the pump frequency of the total pump signal may be the same. The phase difference between the phase of the coupled-in first pump signal portion at the first coupling element and the phase of the coupled-in second pump signal portion at the second coupling element may be determined by the length of the first segment of the pump feed line. Consequently, also the length of the first segment of the pump feed line and/or the length of the first segment of the nonlinear transmission line (and/or the corresponding electrical lengths at the pump frequency or at the target signal frequency) may be configured to ensure the compensation of the phase mismatch accumulated along the first segment of the nonlinear transmission line.

The number of coupling elements of the plurality of coupling elements may be equal or larger than two, three or four.

Optionally, the plurality of coupling elements may comprise a third coupling element. The second and the third coupling element may be connected by the second segment of the nonlinear transmission line. The third coupling element may be configured to couple a third pump signal portion into the nonlinear transmission line at the position of the third coupling element. The position of the third coupling element may correspond to a second interference point. At the second interference point the total pump signal having propagated along the second segment, may interfere with the coupled-in third pump signal portion, thereby again adjusting the phase of the total pump signal in a second phase adjustment.

The second phase adjustment at the second interference point may then correspond to a second jump of the phase of the total pump signal. The second phase adjustment may be configured to compensate at least partially the phase mismatch accumulated between the total pump signal, the target signal and its idler along the second segment of the nonlinear transmission line. Preferably, the phase mismatch is fully compensated.

The total pump signal received at the second interference point from the first and second segment and the third pump signal portion may form an interference signal corresponding to the (new) total pump signal along the third segment, where the total pump signal may be co-propagating with the target signal and its idler for amplifying the target signal. The third segment may be arranged after the second segment in propagation direction of the target signal. The starting point of the third segment may be a position of the third coupling element or the third interference point.

The power and/or phases of the coupled-in pump signal portions can be set/configured to induce at least one phase jump of the phase of the total pump signal at an interference point along the nonlinear transmission line leading to a step-like increase of the phase of the total pump signal. Through the phase jump and/or step-like increase of the total pump signal the phase mismatch between the total pump signal, the target signal and its idler accumulated while co-propagating in the nonlinear transmission line can be compensated at least partially or fully. In general, the plurality of coupling elements can comprise N coupling elements with N being an integer larger or equal to 2. Each pair of the N coupling elements may be connected by a segment of the nonlinear transmission line. A last segment may connect the last coupling element in the series along the nonlinear transmission line and the output of the nonlinear transmission line and/or the output of the TWPA. So, the total number of segments of the nonlinear transmission line may be N as well. The total pump signal may correspond to a superposition of all coupled-in pump signal portions. The phase of the total pump signal may be adjusted (N-1) times along the nonlinear transmission line. Each phase adjustment may correspond to a phase jump at an interference point. The N pump signal portions coupled into the nonlinear transmission line by the N coupling elements of the plurality of coupling elements can thus be configured to induce (N-1) phase jump(s) of the phase of the total pump signal.

The phase of the total pump signal as a function of a distance propagated along the nonlinear transmission line may thus describe a step-like increase with (N-1) steps. A phase adjustment may occur each time an additional pump signal portion is coupled into the nonlinear transmission line and interferes with the pump signal portion(s) and/or the total pump signal already present in the nonlinear transmission line and coming from a preceding segment of the nonlinear transmission line and/or arriving at an interference point.

Each interference point may correspond to the position at which an additional pump signal portion is coupled into the nonlinear transmission line. Each interference point may also coincide with a position of a coupling element or a port of a coupling element of the plurality of coupling elements in and/or along the nonlinear transmission line. Correspondingly, the length of each segment of the nonlinear transmission line between two neighboring interference points may at least approximately correspond to the distance between two neighboring coupling elements.

Each step in the phase of the total pump signal may have the same step height $\varphi_J$. Preferably, a step height $\varphi_J$ of a jump in the phase of the total pump signal and the length $x_J$ of a segment of the nonlinear transmission line fulfill a phase matching condition

$$\tilde{\varphi}_J / x_J = -\Delta k,$$

wherein $\tilde{\varphi}_J = \varphi_J$ when the nonlinearity of the nonlinear transmission line corresponds to a three-wave mixing process or $\tilde{\varphi}_J = 2\varphi_J$ when the nonlinearity of the nonlinear transmission line corresponds to a four-wave mixing process such that a wavevector mismatch $\Delta k$ between the total pump signal, the target signal and its idler along the segment $x_J$ is being compensated at least partially or approximately. The accumulated phase mismatch along the segment may be $x_J \Delta k$. If the step height $\varphi_J$ fulfills exactly the phase matching condition above, the phase mismatch can also be compensated fully at least at an interference point.

The wavevector mismatch $\Delta k$ may comprise a chromatic contribution $\Delta k_C$ and a Kerr contribution $\Delta k_K$. The Kerr contribution may comprise a self-Kerr term for the total pump signal and cross-Kerr terms for target signal and its idler. The chromatic contribution and/or the Kerr contribution may be determined based on a lumped element circuit model of the nonlinear transmission line. For a fixed pump frequency, the wavevector mismatch may depend on the target signal frequency.

The phase matching condition may be part of the theoretical model. The phase matching condition can be used to predict the wavevector mismatch and can be used to choose/configure the length or electrical length of a segment $x_J$ of the nonlinear transmission line, a step height $\varphi_J$ (e.g. for a given length $x_J$ of the segment) and/or a step width $x_J$ of the phase of the total pump signal.

Once the step height $\varphi_J$ is being determined/chosen, the length of a segment of the nonlinear transmission line and/or the length of a segment of the pump feed line (or respective electrical lengths for a given target signal frequency or pump frequency) may be determined using an interference condition.

The electrical length $\varphi_{T1}$ of a segment $x_J$ of the nonlinear transmission line connecting two neighboring coupling elements of the plurality of coupling elements, the electrical length $\varphi_{D1}$ of a segment of the pump feed line connecting the two neighboring coupling elements and the step height $\varphi_J$ of a jump in the phase of the total pump signal may fulfill the interference condition

$$\varphi_{D1} + \varphi_{T1} + \frac{\pi + \varphi_J}{2} = 2\pi l_1$$

, wherein $l_1 > 0$ is an integer and the jump in the phase of the total pump signal with step height $\varphi_J$ leads to at least a partial compensation of the phase mismatch accumulated between the total pump signal, the target signal and its idler along the segment $x_J$ of the nonlinear transmission line. The electrical length $\varphi_{T1}$ of the segment $x_J$ of the nonlinear transmission line connecting two neighboring coupling elements of the plurality of coupling elements and the electrical length $\varphi_{D1}$ of the segment of the pump feed line connecting the two neighboring coupling elements may be evaluated at the same frequency in the interference condition above, e.g., at a pump frequency of the coupled-in pump signal portions.

Expressed in terms of the parameter $\tilde{\varphi}_J$ of the phase matching condition, the length or electrical length $\varphi_{T1}$ of a segment $x_J$ of the nonlinear transmission line and the length or electrical length $\varphi_{D1}$ of a segment of the pump feed line between two neighboring coupling elements (e.g., the first and second coupling element) may at least approximately fulfill the interference condition:

$$\varphi_{D1} + \varphi_{T1} + \frac{\pi + \tilde{\varphi}_J}{2} = 2\pi l_1 \qquad \text{(for three-wave mixing)}$$

or

$$\varphi_{D1} + \varphi_{T1} + \frac{\pi + \tilde{\varphi}_J/2}{2} = 2\pi l_1 \qquad \text{(for four-wave mixing)}$$

wherein $l_1 > 0$ is an integer. By fulfilling the interference condition the step height $\varphi_J$ of the phase of the total pump signal may be realized according to the phase matching condition.

The length or electrical length $\varphi_{D1}$ of a segment of the pump feed line may determine the phase difference between two pump signal portions coupled in the nonlinear transmission line by two (neighboring) coupling elements separated and connected by the segment $x_J$ (e.g. coupled-in first and second pump signal portions). The length or electrical length $\varphi_{T1}$ of a segment of the nonlinear transmission line may determine the additional phase accumulated by the total pump signal (e.g., the coupled-in first pump signal portion) while propagating along the segment. The interference condition thus determines the relative phases of the total pump signal (e.g. the coupled-in first pump signal portion from the first segment) and an additional coupled-in pump signal portion (e.g., the coupled-in second pump signal portion) at an interference point (e.g., the first interference point), wherein the additional coupled-in pump signal portion is coupled into the nonlinear transmission line at the interference point. The theoretical model may also comprise the interference condition.

The nonlinearity mediated by the nonlinear transmission line may correspond to a three-wave or four-wave mixing process. The nonlinear transmission line may comprise a high kinetic inductance material and/or a plurality of Josephson junctions. The plurality of Josephson junctions may be coupled/connected in series to mediate a nonlinearity that converts power from the total pump signal into the target signal and its idler. The nonlinearity mediated by the plurality of Josephson junction may correspond to a three-wave or four-wave mixing process. Optionally, each Josephson junction of the plurality of Josephson junctions may mediate a nonlinearity corresponding to a three-wave or four-wave mixing process.

The nonlinear transmission line may comprise a plurality of Josephson junctions coupled/connected in series by transmission line islands. Each transmission line island coupling/connecting two neighboring Josephson junctions along/in the nonlinear transmission line may comprise a first metal pad and a capacitance to ground (e.g., a capacitive element/gap from the first metal pad to a ground metal plate/layer). The nonlinear transmission line may also comprise galvanic connections coupling/connecting the Josephson junctions and the first metal pads. The first metal pads and the ground metal plate/layer may be made from the same metal.

The nonlinear transmission line may comprise a plurality of lumped element unit cells coupled/connected in series. Each lumped element unit cell of the plurality of lumped element unit cells may comprise at least one Josephson junction mediating a nonlinear interaction. Each unit cell of the plurality of unit cells may also comprise a capacitance to ground.

Advantageously, the nonlinear transmission line and/or the traveling wave parametric amplifier may comprise no closed loops of Josephson junctions and/or flux-biased circuit elements. No DC bias currents may be required to control or adjust the nonlinearity of the nonlinear transmission line.

The plurality of coupling elements may be connected in series by the nonlinear transmission line and/or segments of the nonlinear transmission line. Each segment may connect two neighboring coupling elements along the nonlinear transmission line.

It is noted that the nonlinear transmission line, at least one segment of the nonlinear transmission line or each segment of the nonlinear transmission line may also comprise at least one piece of a linear transmission line, e.g., one or more (small) segments of a linear transmission line inside a coupling element or pieces of linear transmission line coupling directly to a coupling element of the plurality of coupling elements or pieces of linear transmission line connecting subsegments of a segment of the nonlinear transmission line. In this case, the (physical) length and the electrical length of a segment of the nonlinear transmission line may include a (small) contribution from at least one piece of linear transmission line.

The length of each segment of the nonlinear transmission line between/connecting two (nearest) neighboring coupling elements and/or the distance between each two (nearest) neighboring coupling elements of the plurality of coupling elements may correspond to at least a few wavelengths of the target signal, the pump signal portions, the pump tone and/or the total pump signal.

The length of at least one or each segment of the nonlinear transmission line between/connecting two (nearest) neighboring coupling elements and/or the distance between at least or each two (nearest) neighboring coupling elements of the plurality of coupling elements may correspond to at least ten, at least one hundred or at least one thousand lumped-element unit cells.

The total length of the nonlinear transmission line or all segments of the nonlinear transmission line may be larger than 100 or 1000 lumped-element unit cells and/or may be smaller than 10000 lumped-element unit cells.

The TWPA may comprise at least one pump signal generator. The at least one pump signal generator may be configured to generate a pump tone. The pump signal portions may be portions of the pump tone. The at least one pump signal generator and/or the pump feed line may be configured to generate the pump signal portions. The at least one pump signal generator and/or the pump feed line may be configured to set/configure the power and/or phases of the (coupled-in) pump signal portions. The at least one pump signal generator, the pump feed line and/or the plurality of coupling elements may be configured to set/configure the power and/or the phases of the coupled-in pump signal portions. For example, the phase of each pump signal portion and/or coupled-in pump signal portion and/or their relative phase can be set by choosing the length of the section or segment(s) along which the respective pump signal portion propagates along the pump feed line until it reaches the coupling element that is configured to couple the respective pump signal portion into the nonlinear transmission line, e.g., by the path length from the at least one pump signal generator to the respective coupling element. The power of each pump signal portion and/or coupled-in pump signal portion can be set by the power of the pump tone generated by the at least one pump generator and/or by the coupling factors of the plurality of coupling elements (a coupling factor being a measure of the coupling strength between a coupling element and the nonlinear transmission line).

Each coupling element of the plurality of coupling elements may couple a pump signal portion into the nonlinear transmission line via a separate pump feed line. In this case, each coupling element may also be coupled to a separate pump feed line and/or a separate pump signal generator. Each pump signal generator may be configured to generate a (different) pump signal portion.

Alternatively, each coupling element of the plurality of coupling elements may be coupled to the same pump feed line and/or the same pump signal generator. The (same) pump signal generator may be configured to generate a pump tone. The (same) pump feed line may be configured to receive and/or propagate the pump tone. The pump signal portions may be portions of the pump tone generated by the (same) pump signal generator.

The plurality of coupling elements may also be connected in series by the pump feed line and/or segments of the pump feed line. The pump feed line may be a linear (or, equivalently, standard) transmission line. The pump feed line may be configured to receive and propagate a pump tone along the pump feed line. The coupled-in pump signal portions may be (different) portions of the pump tone. The coupled-in pump signal portions, the total pump signal and/or the pump tone may have the same pump frequency.

The interference of the coupled-in pump signal portions can be used to compensate power loss of the total pump signal discretely along the nonlinear transmission line. For example, through the interference a power loss of the total pump signal accumulated while propagating in the nonlinear transmission line can be compensated at least partially or fully. More specifically, the phases and/or power of the coupled-in pump signal portions can be configured such that a power loss of the total pump signal accumulated while propagating in the nonlinear transmission line is being compensated at least partially or fully through the interference. Preferably, the power of the total pump signal is being recovered discretely along the nonlinear transmission line through the interference such that the power of the total pump signal is approximately the same at each coupling element of the plurality of coupling elements and/or at each interference point and the first coupling element along the nonlinear transmission line in the propagation direction of the target signal. In this way, the Josephson junctions can be fabricated identically and/or can be operated at the same ratio of pump current to critical current.

Optionally, the power of the pump signal portions coupled into the nonlinear transmission line by the plurality of coupling elements are chosen such that the power of the total pump signal as resulting from the interference of the coupled-in pump signal portions at discrete interference points along the nonlinear transmission line is the same at least at the respective interference points. In this case, the power of the total pump signal is being recovered at each interference point such that losses in the total pump signal occurring while propagating along segments of the nonlinear transmission line can be compensated at least approximately and discretely at each interference point.

Optionally, when the plurality of coupling elements comprise a first coupling element configured to couple a first pump signal portion from the pump feed line into the nonlinear transmission line at a first location and a second coupling element configured to couple a second pump signal portion from the pump feed line into the nonlinear transmission line at a second location, wherein the second location corresponds to a first interference point and the total pump signal at the first interference point results from the interference of the coupled-in second pump signal portion with the coupled-in first pump signal portion having propagated along a first segment of the nonlinear transmission line between the first location and the first interference point, the power of the coupled-in first pump signal portion at the first location may be the same as the power of the total pump signal at the first interference point. Here, the power of a signal corresponds to the absolute square of the amplitude of the respective signal.

When the plurality of coupling elements comprise more than two coupling elements connected in series by segments of the nonlinear transmission line, the length and/or electrical length of the connecting segments of the nonlinear transmission line may be the same. Each segment of the nonlinear transmission line may be arranged between and connect two (different) neighboring coupling elements of the plurality of coupling elements along the nonlinear transmission line.

Alternatively, or additionally, when the plurality of coupling elements comprise more than two coupling elements connected in series by segments of the pump feed line, the length and/or electrical length of at least two of the connecting segments of the pump feed line may be different. Each segment of the pump feed line may be arranged between and connect two (different) neighboring coupling elements of the plurality of coupling elements along the pump feed line.

At least outside the coupling elements of the plurality of coupling elements, the pump feed line and the nonlinear transmission line may be spaced apart from one another. The segments of the nonlinear transmission line and the pump feed line connecting the same two neighboring coupling elements may be spaced apart from one another.

Advantageously, the nonlinear transmission line, the pump feed line and the plurality of coupling elements can be co-integrated on-chip, i.e., on a same chip. The chip may be a superconducting chip. Optionally, the pump feed line, the plurality of coupling elements and/or the nonlinear transmission line are co-integrated in a co-planar waveguide geometry.

Preferably, the nonlinear transmission line, the pump feed line and the plurality of coupling elements are co-integrated over the same substrate and/or in the same superconducting chip.

The TWPA can comprise a substrate, a patterned first metal layer over or directly on the substrate and Josephson junctions over or directly on the substrate and/or over or directly on the patterned first metal layer. The patterned first metal layer can comprise first metal pads. The Josephson junctions may be arranged in gaps in between the first metal pads. The Josephson junctions may also at least partially overlap the first metal pads.

The TWPA may also comprise galvanic connections that couple/connect the Josephson junctions with the first metal pads.

The patterned first metal layer may also comprise ground metal plates and capacitive couplings (capacitances to ground) between the ground metal plates and the first metal pads. The patterned first metal layer may also define and/or comprise the pump feed line and/or the plurality of coupling elements.

The substrate may be a Silicon substrate. The patterned first metal layer can be a superconducting metal layer. Optionally, the patterned first metal layer may comprise Niobium or can be made of Niobium. The patterned first metal layer may be a patterned thin Niobium film. The TWPA may also comprise air-bridges across the nonlinear transmission line and/or the pump feed line for the suppression of spurious modes.

The Josephson junction(s) can comprise a second metal layer/pad(s), an oxide layer and a third metal layer/pad(s). The second metal layer/pad(s) may be directly on the substrate (e.g., in gaps in between the first metal pads). The oxide layer may be over or on the second metal layer/pad(s). The third metal layer/pad(s) may be over or on the oxide layer. The second metal layer/pad(s) and/or the third metal layer/pad(s) may comprise or may be made of Aluminum. The oxide layer may be an aluminum oxide layer. The Josephson junctions may be operated below their critical currents. Their critical currents may be in the range of microamperes. The Josephson junctions may be fabricated using e-beam lithography and/or shadow evaporation and/or double-angle evaporation. The TWPA may therefore exhibit high coherence and essentially zero insertion loss into the nonlinear transmission line. This may lead to high gain.

Optionally, galvanic connections that may connect/couple the first metals pads with the Josephson junctions may comprise a fourth metal layer. The galvanic connections and/or the fourth metal layer (e.g., at least portions thereof) may at least partially overlap with the first metal pads and the Josephson junctions. The galvanic connections and/or the fourth metal layer (e.g., at least portions thereof) may also be arranged directly on the first metal pads and the Josephson junctions. Additionally, the galvanic connections and/or the fourth metal layer (e.g., at least portions thereof) may also be arranged directly on the substrate.

At least one or each coupling element of the plurality of coupling elements may be a directional coupler. At least one or each coupling element or directional coupler of the plurality of coupling elements may also be an in-line or coupled-line directional coupler. The nonlinear transmission line may be interrupted and segmented by the directional couplers. Each pair of nearest neighbor directional couplers may be connected by a segment of the nonlinear transmission line. The beginning of the segment may correspond to an output port of a first directional coupler of a pair and the end of the segment may correspond to the input port of the second directional coupler of the pair.

At least one or each directional coupler may comprise four ports. At least one or each directional coupler may comprise a first (target signal) input port and a first output port connected to the nonlinear transmission line. At least one or each directional coupler may comprise a second (pump tone) input port connected to the pump feed line and a second output port.

At least one or each directional coupler may be configured to let the target signal and its idler (or at least a part thereof) transmit through the directional coupler via the first input port and the first output port. The first input port and the first output port may be non-isolated ports.

At least one or each directional coupler may be configured to let (at least a portion of) the pump tone transmits through the directional coupler via the second input port and the second output port. At least one or each directional coupler may be configured to couple a pump signal portion into the nonlinear transmission line via the second input port and/or the first output port. The second input port may be an isolated port. The second output port may be a non-isolated port.

Eat least one or each directional coupler may be a backward/reverse coupler. At least one or each directional coupler may be a quarter-wave coupler, wherein a wavelength corresponds to the wavelength of the pump tone or (coupled-in) pump signal portion. At least one or each directional coupler may be co-planar waveguide coupler. At least one or each directional coupler may be a phase-preserving coupler.

The traveling wave parametric amplifier may also comprise an additional coupling element. The additional coupling element may be a directional coupler as described further above. The additional coupling element may be arranged after the plurality of coupling elements along the nonlinear transmission line in the propagation direction of the target signal. The plurality of coupling elements and the additional coupling element may be connected by the last segment of the nonlinear transmission line in target signal propagation direction.

The additional coupling element may be configured to bring an additional pump signal portion into destructive interference with the total pump signal after the total pump signal has co-propagated with the target signal and its idler along the nonlinear transmission line in order to suppress or cancel the total pump signal at an output of the nonlinear transmission line and/or in subsequent circuit elements used for further processing of the amplified target signal, e.g., to avoid saturation of subsequent amplifiers or amplification stages.

The invention also relates to a method of manufacturing a traveling wave parametric amplifier according to any one of the aspects described further above, wherein the nonlinear transmission line comprises Josephson junctions coupled in series. The method comprises forming a first metal layer over a substrate, patterning the first metal layer, and forming the Josephson junctions over the substrate and/or over the patterned first metal layer.

In particular, when the first metal layer is formed and patterned before the Josephson junctions are formed, various large-scale transmission line structures may be formed and fabricated in the first metal layer before the Josephson junctions are manufactured locally at pre-determined positions. The large-scale structures may comprise ground metal plates, first metal pads, gaps in between the first metal pads for depositing the Josephson junctions and/or galvanic connections, gaps in between the first metal pads and the ground metal plates for forming capacitances to ground, the plurality of coupling elements (or at least parts thereof) and/or the pump feed line (or at least parts thereof).

In this way, such large-scale structures can be formed in the bottom most first metal layer that is on or closest to the substrate rather than arranging those structures in layers that are above the Josephson junctions as seen from the substrate. When large-scale patterning would be required over or on top of the Josephson junctions, those large-scale patterning steps may negatively affect the delicate Josephson junction structures and cause misalignment, spurious couplings, additional dielectric losses and further detrimental effects. Instead, in the proposed method no further large-scale patterning steps on the first metal layer may be required after the fabrication of the Josephson junctions. This facilitates large-scale fabrication of those structures with high precision and speed.

Optionally, the patterning of the first metal layer comprises forming first metal pads. The patterning of the first metal layer may comprise etching gaps in the first metal layer in between the first metal pads for forming Josephson junctions in a later step. Optionally, the patterning of the first metal layer may comprise forming ground metal plates. The patterning of the first metal layer can comprise etching gaps between the first metal pads and the ground metal plates for forming capacitances to ground.

Each capacitor to ground may be arranged in between (interleaving) two neighboring Josephson junctions coupled/connected in series. The capacitors to ground of the nonlinear transmission line may be realized as co-planar waveguide (CPW) capacitors on a (high coherence) Niobium (Nb) film. In this way, the usage of lossy and thin dielectrics may be avoided contributing to high gain values that can be maintained over a broad frequency range.

The patterning of the first metal layer may also comprise forming the pump feed line and/or the plurality of coupling elements.

The method may also comprise forming the galvanic connections for coupling and/or connecting the Josephson junctions and the first metal pads. The galvanic connections may comprise metallic pads or bandages that galvanically connect the Josephson junctions to the first metal pads.

The nonlinear transmission line may comprise the first metal pads, the Josephson junctions, the galvanic connections and/or the capacitances to ground. The method may comprise forming air bridges over the pump feed line and/or the nonlinear transmission line.

The invention also relates to a method for amplifying a target signal. The method comprises receiving and propagating, by a nonlinear transmission line, the target signal. The method further comprises coupling, by each coupling element of a plurality of coupling elements, a pump signal portion from a pump feed line into the nonlinear transmission line. The coupled-in pump signal portions forming a total pump signal co-propagating in the nonlinear transmission line in the same direction as the target signal for amplifying the target signal. The coupling elements of the plurality of coupling elements are arranged at a distance from one another along the nonlinear transmission line. The method also comprises bringing the coupled-in pump signal portions into interference with respect to each other in the nonlinear transmission line. The method further comprises configuring the phases of the coupled-in pump signal portions such that a phase mismatch between the total pump tone, the target signal and its idler accumulated while co-propagating in the nonlinear transmission line is being compensated at least partially or approximately through their interference, i.e., the interference of the coupled-in pump signal portions inside the nonlinear transmission line.

The target signal may comprise a plurality of signals/tones with different frequencies. In this way, frequency-multiplexed readout may be realized.

By configuring the phases of the coupled-in pump signal portions, the (electrical) length of a/the segment(s) of the pump feed line between two neighboring coupling elements and/or the (electrical) length of a/the segment(s) of the nonlinear transmission line between two neighboring coupling elements, the interference may be tuned and can be arranged to fulfill the phase matching condition at least approximately.

Additionally, or alternatively, the method for/of amplifying the target signal may also comprise adjusting and/or fine-tuning the pump frequency and/or the pump power to fulfill the phase matching condition (discussed further above).

Optionally, the amplitudes of the coupled-in pump signal portions can also be configured and/or adjusted. Preferably, the amplitudes are configured to compensate losses of the total pump signal induced while propagating along (segments of) the nonlinear transmission line. This may potentially increase the saturation power and/or the gain of the traveling wave parametric amplifier.

Optionally, the amplitude of a coupled-in pump signal portion can be configured to increase the amplitude of the total pump signal in a segment of the nonlinear transmission line comprising Josephson junctions with a larger critical current (a so-called "booster" segment) than in the preceding segment of the nonlinear transmission line in relation to the propagation direction of the target signal, e.g., in order to increase the dynamic range of the parametric amplifier.

The method may further comprise determining the length and/or electrical length of a segment of the nonlinear transmission line and/or the step height of a phase jump of the phase of the total pump signal according to a phase matching condition and/or an interference condition such that the phase jump compensates a wavevector mismatch accumulated between the total pump signal, the target signal and its idler along a/the segment of the nonlinear transmission line. The method may further comprise choosing the length and/or electrical length of a segment of the nonlinear transmission line according to the determined result.

The method may further comprise determining the length and/or electrical length of a segment of the pump feed line according to an interference condition such that the phase jump compensates a wavevector mismatch accumulated between the total pump signal, the target signal and its idler along a/the segment of the nonlinear transmission line according to the phase matching condition. The method may further comprise choosing/configuring the phases of coupled-in pump signal portions according to the determined result.

The invention also relates to a computer program comprising instructions which, when the program is executed by a computer using a traveling wave parametric amplifier, cause the computer to carry out the method for amplifying a target or any combination of its features as described above.

The computer program (or a sequence of instructions) may use software means for performing the method for amplifying a target signal when the computer program runs in a computing unit. The computer program can be stored directly in an internal memory, a memory unit, or the computer.

The invention also relates to a computer-readable data carrier having stored there on the computer program described above. The computer program can be stored in machine-readable data carrier(s), preferably digital storage media.

The proposed invention facilitates dispersion-less, discrete phase matching by adjusting the phase of the pump tone interferometrically. Advantageously, the phase of the total pump signal may be adjusted only a few times along the nonlinear transmission line, i.e., on the scale of a few wavelengths in the TWPA medium. At the same time high gain coefficients in a broad frequency range can be achieved. Moreover, the proposed dispersion-less, discrete phase matching technique creates no stopband and can be implemented with very few additional circuit elements. The center of the gain profile and the saturation power of the nonlinear transmission line can be tuned and adjusted. For example, the full width at half maximum (FWHM) of the gain profile may be at least two or a few Gigahertz (GHz) enabling frequency-multiplex readout.

The invention can be applied in a wide range of technological areas. For example, the invention can be applied to quantum-limited amplification of microwave signals. This can be used for high-fidelity multiplexed readout of superconducting qubits with applications in quantum computing or quantum simulation. In addition, there exist applications in astronomy.

**Detailed Description**

Exemplary embodiments of the invention are illustrated in the drawings and will now be described with reference to figures 1 to 15.

In the figures:

Fig. 1    shows an embodiment of a traveling wave parametric amplifier,
Fig. 2    shows a phasor representation of interference,
Fig. 3    shows a phasor representation of interference at a second and third coupling element,
Fig. 4    shows a step-like increase of the phase of the total pump signal along the nonlinear transmission line,
Fig. 5    shows a modulus of a Fourier coefficient,
Fig. 6    shows a modulus of the phase matching Fourier coefficient,
Fig. 7    shows embodiments of the nonlinear transmission line,
Fig. 8    shows a parameter table for a traveling wave parametric amplifier with four coupling elements,
Fig. 9    shows a gain profile for a traveling wave parametric amplifier with four coupling elements,
Fig. 10   shows the gain as a function of the distance for a traveling wave parametric amplifier with four coupling elements,
Fig. 11   shows a parameter table for a traveling wave parametric amplifier with two coupling elements,
Fig. 12   shows a gain profile for a traveling wave parametric amplifier with two coupling elements,
Fig. 13   shows the gain as a function of the distance for a traveling wave parametric amplifier with two coupling elements,

Fig. 14    shows gain profiles for different step heights for a traveling wave parametric amplifier with two coupling elements,

Fig. 15    shows a wave vector mismatch,

Fig. 16    shows an embodiment of a Josephson with galvanic connections.

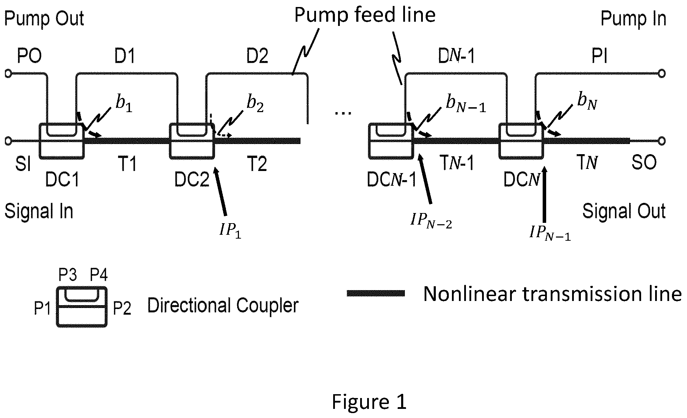

Figure 1 shows an embodiment of a traveling wave parametric amplifier (TWPA) for amplifying a target signal. The TWPA comprises a nonlinear transmission line for receiving and propagating the target signal. The nonlinear transmission line comprises $N$ nonlinear transmission line sections $Tn$ ($n$ = 1, ... , $N$), also denoted as TWPA sections for the remainder. The nonlinear transmission line may also be denoted as TWPA line in the following.

The TWPA also comprises a plurality of $N$ directional couplers DC$n$ as coupling elements with coupling factors $C_n$ ($n$ = 1..., $N$), connecting the multiple TWPA sections through their input and output ports.

A pump feed line comprises a plurality of pump feedline sections $Dn$ configured to receive a pump tone. The pump feed line is a standard, i.e., a linear, transmission line. The directional couplers DC$n$ are connected by the nonlinear transmission line segments $Tn$ and the pump feed line sections $Dn$ in series.

The pump tone propagates from the pump input port (Pump In) and the linear transmission line PI through the directional couplers DC$n$ and via the pump feed line segments $Dn$ towards the linear transmission line PO and the pump output port (Pump Out). The pump output port comprises a 50 Ohm terminator that dissipates the (remaining) pump signal received at the pump output port such that no pump signal is reflected at the pump output port (i.e. reflected back into the pump feed line). The pump signal portions $b_n$ are portions of the pump tone and are coupled via the plurality of directional couplers DC$n$ into the multiple TWPA sections $Tn$ of the nonlinear transmission line.

The target signal propagates from the signal input port (Signal In) and the linear transmission line SI through the directional couplers DC$n$ and via the nonlinear transmission line sections Tn to the linear transmission line SO and the signal output port (Signal Out).

The pump feed line and the nonlinear transmission line comprise coplanar waveguide (CPW) structures. The nonlinear transmission line comprises Josephson junctions coupled/connected in series and manufactured using double-angle evaporation. Compared to other device designs and fabrication techniques, the proposed approach does not involve lossy and thin dielectrics. We therefore expect loss tangents at least one order of magnitude lower, translating in a higher quantum efficiency and amplification efficiency.

The directional couplers are implemented as coupled-line directional couplers also in a CPW geometry. In one realization each directional coupler comprises a $\lambda$/4-long coupling section, i.e., a so-called $\lambda$/4-coupler, where $\lambda$, is the wavelength for which the directional coupler is optimized, which is the wavelength of the pump tone in our case. However, other realizations of an in-line directional coupler are also possible.

The plurality of directional couplers DC$n$ are arranged at a distance from one another along the nonlinear transmission line. The input port P1 $_n$ of each directional coupler DC$n$ with $n$ > 1 is connected to the end of the previous/preceding TWPA section, $Tn$ - 1. The input port of the first directional coupler DC1 is connected to the signal input port of the TWPA via a linear transmission line SI. The output port P2 $_n$ of each directional coupler DC$n$ is connected to the beginning of the next TWPA section T$n$ along the nonlinear transmission line. The last TWPA section T$n$ is connected to the signal output port via a linear transmission line SO.

Furthermore, the isolated port P4 $_n$ of each directional coupler DC$n$, via which a pump signal portion $b_n$ is coupled into the TWPA section T$n$, is connected to the coupled port P3 $_{n+1}$ of the next directional coupler DC$n$ + 1 using a linear transmission line section, i.e., the pump feed line section Dn. The isolated port P4 $_N$ of the last directional coupler is connected to the pump input port via a linear transmission line PI and the coupled port P3 $_1$ of the first directional coupler DC1 is connected to the pump output port using a linear transmission line PO. Alternatively, the coupled port P3 $_1$ of DC1 may be terminated.

Each directional coupler DC$n$ is configured to couple a pump signal portion $b_n$ from the pump feed line into the nonlinear transmission line. In the nonlinear transmission the coupled-in pump signal portions $b_n$ form a total pump signal co-propagating in the nonlinear transmission line in the same direction as the target signal for amplifying the target signal. The coupled-in pump signal portions $b_n$, the pump tone and the total pump signal have the same pump frequency.

The nonlinear transmission line and the plurality of directional couplers DC$n$ are further configured to bring the coupled-in pump signal portions $b_n$ into interference with respect to each other along the nonlinear transmission line, wherein through the interference a phase mismatch between the total pump signal, the target signal and its idler accumulated while co-propagating in the nonlinear transmission line is being compensated at least partially.

The coupling factors $C_n$ of the directional couplers are small (< -10 dB) so that (i) the pump tone is reduced only little when passing via P4 $_n$ and P3 $_n$ through a directional coupler DC$n$ and (ii) the target signal is reduced only little when passing via P1 $_n$ and P2 $_n$ through a directional coupler DC$n$. For clarity, the coupling factor of a directional coupler is defined as

$$C = 10\log(P_3/P_1) = 10\log(P_4/P_2) \qquad (1)$$

for an input power $P_1$ at a port P1 $_n$ and an output power $P_3$ at a port P1 $_n$ with all other ports terminated, or, equivalently, for an input power $P_2$ at port P2 $_n$ and an output power $P_4$ at a port P4 $_n$ with all other ports terminated.

At each isolated port P4 $_n$ of a directional coupler DCn a pump signal portion $b_n$ of the pump tone is coupled into the TWPA section Tn (see dashed arrow in Fig. 1, e.g., at DC2), interfering with the coupled-in pump signal portion(s) already incident from section Tn - 1 and resulting in a total pump signal with its phase changed by a value $\varphi_{Jn}$ in section Tn as compared to a situation where no pump power would be applied at port P4 $_n$. We note that $\varphi_{J0}$ =0 because there is no coupled-in pump signal portion or total pump signal incident at the input port P1 $_1$ of DC1 and thus no interference.

If each phase jump $\varphi_{Jn}$ (n = 2, ... , N) is chosen to at least partially or approximately undo/compensate the phase mismatch accumulated between total pump signal, target signal and its idler tone in section Tn - 1, effective phase matching in the TWPA and thus efficient amplification of the target signal is achieved.

Analogously to the phase adjustments, there is the possibility to also adjust the amplitude of the total pump signal for each TWPA section, e.g. to compensate for loss occurring in the preceding TWPA section or to increase the pump power for a subsequent TWPA booster section with a larger critical current for achieving a higher dynamic range.

Further below, we describe in detail how to realize a phase difference $\varphi_{Jn}$ resulting in a phase jump that at least partially compensates an accumulated phase mismatch. For clarity, we focus on the case of constant pump amplitudes of the total pump signal for all TWPA sections Tn (and neglect a small fraction of pump power coupled out to the coupled port P3 $_n$ and assume no losses in the nonlinear transmission line). We define an interference point $IP_{n-1}$ in/at each directional coupler DCn as the point at which the pump signal portion $b_n$ incident from the pump feedline section Dn and the total pump signal incident from the previous/preceding TWPA section Tn - 1 meet and effectively interfere. At the interference point $IP_{n-1}$ the pump amplitude or pump signal portion coming from Dn is denoted as $b_n$, and the pump amplitude or total pump signal coming from Tn - 1 as $a_n$ (i.e., corresponding to the total pump signal at the directional coupler DCn right before the interference with the pump signal portion $b_n$). For example, $a_2$ corresponds to the first pump signal portion $b_1$ after having propagated along the first TWPA segment T1. Note, that along the first segment T1 the first pump signal portion $b_1$ corresponds to the total pump signal.

Recurring features are provided in the following figures with identical reference signs as in Figure 1.

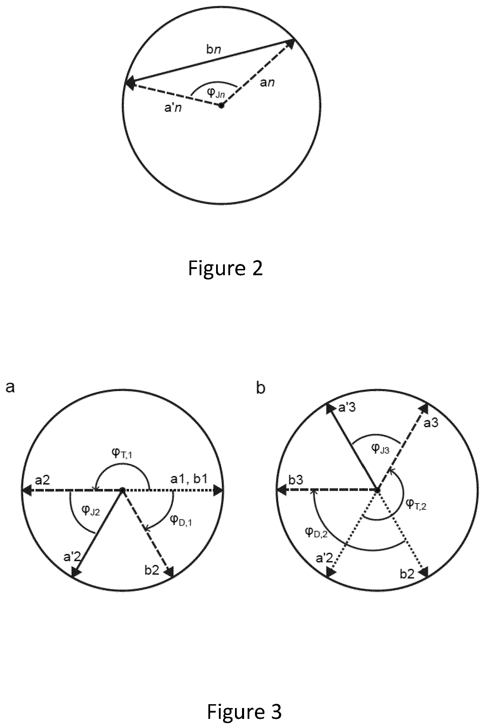

Figure 2 shows a phasor representation of interference explained now in more detail. The power amplitude or total pump signal amplitude $a'_n$ results from interference of the amplitude $a_n$ of the total pump signal just before it reaches an interference point $IP_{n-1}$ and the coupled-in signal portion $b_n$ coupled into the nonlinear transmission line right at the interference point $IP_{n-1}$. In Figure 2, for a given $\varphi_{Jn}$, the power $|b_n|^2$ (or absolute value of the amplitudes) of the coupled-in pump signal portions are chosen such that the power of the total pump signal $|a'_n|^2$ as resulting from the interference of the coupled-in pump signal portions at the discrete interference points $IP_{n-1}$ along the nonlinear transmission line is the same at least at the respective interference points $IP_{n-1}$ (corresponding to the locations of the directional couplers). In case power loss of the total pump signal occurs in a segment of the nonlinear transmission line preceding the interference point $IP_{n-1}$, the relative phase of $a_n$ and $b_n$ and/or the power $|b_n|^2$ may be adjusted to compensate for that power loss such that the power of the total pump signal is approximately the same at each interference point $IP_{n-1}$ and at the corresponding location of the first coupling element DC1.

Power relations

The following equations apply to the case $n$ > 1. To realize a phase difference $\varphi_{Jn}$ at DCn, the ratio of the moduli squared of the respective pump amplitudes is

$$|b_n|^2/|a_n|^2 = 2(1 - \cos\varphi_{Jn}), \qquad (2)$$

The modulus of the coupled-in pump amplitude $|b_n|$ is set by the coupling factor $C_n$ and by the pump power incident at P4 $_n$, i.e.

$$|b_n|^2 = 10^{C_n/10} P_{P4,n}, (3)$$

where $P_{P4,n}$ is the pump power incident at port P4 $_n$. Furthermore, for constant pump amplitudes $|a_n|$ in all TWPA sections, we have

$$|a_n|^2 = |b_1|^2 = 10^{C_1/10} P_{P4,1}. \qquad (4)$$

Inserting Eq. (3) and Eq. (4) into Eq. (2) yields an expression for the required coupling factors $C_n$ ($n > 1$):

$$C_n = C_1 + 10\log\big(2(1 - \cos\varphi_{Jn})\big) + 10\log\big(P_{P4,1}/P_{P4,n}\big). \quad (5)$$

Using $P_{P4,1} = P_{P4,n} \prod_{l=2}^{n} \left(1 - 10^{C_l/10}\right)$, one can solve for all coupling factors $C_n$ ($n > 1$), starting with $n$ = 2. The choice of $C_1$ is made as a compromise between having low signal loss through the coupled port $P3_1$ and having a not too large pump power in the pump feed line which could aggravate problems related to crosstalk or power handling. Alternatively, we can just approximate $C_n \approx C_1 + 10\log(2(1 - \cos\varphi_{Jn}))$ because all coupling factors are small and thus little power is lost when the pump tone or pump feed signal passes through a directional coupler. Another practical way of getting the right relation between all coupling factors is taking into account the small power drops at each directional coupler, and to set $\tilde{C}_n = C_1 + 10\log(2(1 - \cos\varphi_{Jn}))$ in a first step and then calculate the corrected coupling factors $C_n$ ($n < N$) as

$$C_n = \tilde{C}_n - \sum_{m>n} 10\log(1 - 10^{C_m/10}) \qquad (6)$$

in a second step, starting with $C_{N-1}$.

Phase relations

With the power ratio Eq. (2) and the coupling factors fixed, we still need to derive conditions for the phase relation between $b_n$ and $a_n$ in order to realize a target $\varphi_{Jn}$. With the help of the phasor diagram in Figure 2 we obtain the condition

$$\arg(b_n) - \arg(a_n) = \frac{\pi}{2} + \frac{\varphi_{Jn}}{2} \quad n \geq 2. \qquad (7)$$

The phases of the complex amplitudes $b_n$ and $a_n$ are determined by the electrical lengths $\varphi_{D,n} > 0$ of the pump feed line sections and by the electrical lengths $\varphi_{T,n} > 0$ of the nonlinear transmission line sections. We define $\varphi_{D,n}$ as the electrical length in the pump feed line between the n-th and ($n + 1$)-th directional coupler, referenced e.g. to port P4 of each directional coupler. Similarly, $\varphi_{T,n}$ is the electrical length in the nonlinear transmission line between the $n$-th and ($n + 1$)-th directional coupler, referenced e.g. to port P2 of each directional coupler. For completeness, we note that $\varphi_{Tn}$ also includes a Kerr phase accumulated in a TWPA section, see also more detailed explanations regarding the Kerr terms further below. Here, the electrical length $\varphi_{T,n}$ also includes a small contribution from a piece of linear transmission line inside the directional coupler DC$n$ (i.e. the through part of a directional coupler). We now derive the conditions for $\varphi_{D,n}$ and $\varphi_{T,n}$ that fulfill Eq. (7).

We first note that the phase of $b_1$ sets the initial phase of the total pump signal propagating along the first segment of the nonlinear transmission line. Without loss of generality, we can set the phase of $b_1$ to zero. The amplitudes $b_n$ and $a_n$ for $n \geq 2$ are then given by

$$b_n = |b_n|\exp\left(-i \sum_{k=1}^{n-1} \varphi_{D,k}\right) \qquad (8)$$

$$a_n = |a_n|\exp\left(+i \sum_{k=1}^{n-1} (\varphi_{T,k} + \varphi_{Jk})\right) \qquad (9)$$

Eq. (7) for $n = 2$ translates into the interference condition (phase relation condition)

$$\arg(b_2) - \arg(a_2) = -\varphi_{D1} - \varphi_{T1} + 2\pi l_1 = \frac{\pi}{2} + \frac{\varphi_{J2}}{2},$$

$$\Leftrightarrow \quad \varphi_{D1} + \varphi_{T1} + \frac{\pi + \varphi_{J2}}{2} = 2\pi l_1, \qquad (10)$$

with an integer $l_1 > 0$, which is determined by how many wavelengths fit into a TWPA line section and a pump feed line section (neglecting the term $\pi/2 + \varphi_{J2}/2$).

Figure 3 shows a phasor representation of interference at the second and third directional couplers. Panel (a) shows the interference at the second directional coupler DC2 for $\varphi_{J2} = \pi/3$. Panel (b) shows the interference at the third directional coupler DC3 for $\varphi_{J3} = \pi/3$. The amplitudes $a'_n$ result from interference of the amplitudes $a_n$ and $b_n$. In particular, the phasor diagram in Panel (a) of Figure 3 illustrates an example with $\varphi_{J2} = \pi/3$, for which $|a_n| = |b_n|$.

In general, for arbitrary $n = 2, \ldots , N$ and recalling $\varphi_{J1} = 0$, we obtain

$$\arg(b_n) - \arg(a_n) =$$

$$\sum_{k=1}^{n-1} \left(-\varphi_{Dk} - \varphi_{Tk} - \varphi_{Jk} + 2\pi l_k\right) = \frac{\pi}{2} + \frac{\varphi_{Jn}}{2}, \qquad (11)$$

with positive integers $l_n > 0$.

Using Eq. (11) for $n \to n - 1$ we obtain, valid for $n \geq 3$, the interference condition

$$\varphi_{Dn-1} + \varphi_{Tn-1} + \frac{\varphi_{Jn-1} + \varphi_{Jn}}{2} = 2\pi l_{n-1}. \qquad (12)$$

To provide some intuition, we briefly consider the case of equal phase differences $\varphi_{Jn} = \varphi_J$ corresponding to equal phase jumps in the phase of the total pump signal. Eq. (12) then dictates that for $n \geq 2$ the sum of the electrical length $\varphi_{Dn}$ in the pump feed line and the effective electrical length $\varphi_{Tn} + \varphi_{Jn}$ in the TWPA line, consisting of the standard electrical length $\varphi_{Tn}$ and the phase jump $\varphi_{Jn}$, should be a multiple of $2\pi$. This makes sense as the correct interference condition is already initiated at DC2 (via Eq. (10)) and the same condition shall be met at all other DCn with $n \geq 3$. An example of the interference at DC3 is given in panel (b) of Figure 3 for $\varphi_J = \pi/3$.

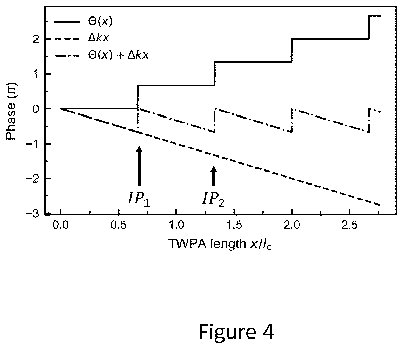

It is noted, that the phase difference parameter $\varphi_J$ corresponds to the step height of the phase jump of the total pump signal, e.g. at the first interference point $IP_1$ (see also Eq. (31) and Figure 4 and corresponding description further below).

Summarizing, Eq. (12) and Eq. (10) can be used to determine the electrical lengths ($\varphi_{Dn}$, $\varphi_{Tn}$), which realize the target $\varphi_{Jn+1}$ for a constant TWPA pump amplitude $|a_n| = |b_1|$. The values $\varphi_{Jn}$ are chosen to undo/compensate the phase mismatch accumulated in the TWPA section T$n$ - 1, for its choice see explanations further below.

Fine-tuning the pump frequency

We argue that a design with equal phase differences $\varphi_{Jn} = \varphi_J$, corresponding identical TWPA sections T$n$ ($n = 1, \ldots, N$ - 1) with the same electrical lengths $\varphi_{Tn} = \varphi_T$, identical pump feed line sections D$n$ ($n = 2, \ldots , N$ - 1) with identical electrical lengths $\varphi_{Dn} = \varphi_{D2}$, and equal $2\pi$-multiplicity, i.e. $l_n - l_{n-1} = l_1$, is of high practical relevance and chosen in one embodiment. Note, that the electrical length $\varphi_{D1}$ of the first segment D1 of the pump feed line shall be different from the electrical length $\varphi_{D2}$ of the second segment D2 of the pump feed line as will be explained in the next sections.

An identical design for the phase differences and the TWPA sections allows for tuning up the TWPA and the gain by fine-tuning of the single parameter $\omega_p$, given a fixed pump power. Here, $\omega_p$ is the pump frequency in radians.

Such a parameter choice also allows for operating the TWPA not only at a single optimal pump frequency $\omega_{p,opt}$ close to the target or design pump frequency $\omega_{p,0}$ (i.e., the pump frequency for which the electrical lengths $\varphi_{Dn}$ and $\varphi_{Tn}$ have

$$\Delta\omega_{\mathrm{p}} \approx q \cdot \frac{\omega_{p,\mathrm{opt}}}{l_1}$$

been determined/optimized), but also at pump frequencies differing from $\omega_{p,opt}$ by a value with $q = \pm 1, \pm 2, \ldots$. To understand this, we write down Eq. (12) and Eq. (10) for the reduced parameter set ($\varphi_T$, $\varphi_J$, $\varphi_{D1}$, $\varphi_{D2}$, $l_1$).

$$\varphi_{D2} + \varphi_T + \varphi_J = 2\pi l_1, \qquad (13)$$

$$\varphi_{D1} + \varphi_T + \frac{\varphi_J + \pi}{2} = 2\pi l_1 \qquad (14)$$

From these equations it is already clear that the electrical lengths of the first and second segments of the pump feed line are different. Hence, former Eq. (12) has reduced to a single equation Eq. (13), and Eq. (14) can be cast into

$$\varphi_{D1} = \varphi_{D2} - \left(\frac{\pi - \varphi_J}{2}\right) \qquad (15)$$

using Eq. (13). Eq. (15) can be considered as an additional interference condition to be obeyed by the respective electrical lengths $\varphi_{D1}$, $\varphi_{D2}$ of the first and second pump feed line sections.

The electrical lengths $\varphi_{Dn}$ and $\varphi_T$ are approximately proportional to $\omega_p$, i.e. we can write

$$\varphi_{Dn}(\omega_p) \approx \frac{\varphi_{Dn,0}}{\omega_{p,0}} \omega_p \quad n = 1,2, \qquad (16)$$

$$\varphi_T(\omega_p) \approx \frac{\varphi_{T,0}}{\omega_{p,0}} \omega_p, \qquad (17)$$

where $\varphi_{Dn,0}$ and $\varphi_{T,0}$ are the electrical lengths at the target/design pump frequency $\omega_{p,0}$ realized in the fabricated device, i.e. according to the parameter values characterizing the device as it came out of fabrication. These values may differ slightly from the (target) electrical lengths due to model imperfections, fabrication imperfections etc.

Hence, if we fulfill Eq. (15) by correctly designing the transmission line lengths of the pump feed line sections D1 and D2 for the target pump frequency, i.e. if $\varphi_{Dn,0} \approx \varphi_{Dn,t}$ with $\varphi_{Dn,t}$ the target electrical lengths, we can fine-tune $\omega_p$ in the experiment to fulfill Eq. (13) in the presence of deviations $\varphi_{T,0}$ from the target value $\varphi_{T,t}$, while Eq. (15) remains approximately fulfilled. The latter is the case because $|\varphi_{D1} - \varphi_{D2}| \ll \varphi_T$ and thus Eq. (15) with the term $\varphi_{D1} - \varphi_{D2}$ varies much less with $\omega_p$ than Eq. (13) with the term $\varphi_T + \varphi_{D2}$. We emphasize that $\varphi_T$ shall be tuned via tuning $\omega_p$: First, the Kerr phase shift makes $\varphi_T$ pump power-dependent and the optimal pump power is a priori not known. Second, the phase velocity in the TWPA sections depends stronger on fabrication variations than the phase velocity of the linear pump feed line sections.

As a practical consideration we mention that it is advantageous if the physically realized TWPA sections Tn have sufficiently identical electrical lengths $\varphi_{Tn,0} \approx \varphi_{T,0}$ so that the consideration of a single $\varphi_T$, as assumed during the derivation in this section, is valid. An exception is the special case of only two TWPA sections, i.e. $N = 2$, for which only a single condition Eq. (14) exists.

We now turn to the possibility of operating the TWPA at various pump frequencies. As pointed out above, fine-tuning of $\omega_p$ results in an optimal pump frequency $\omega_{p,opt}$ for which the gain profile of the TWPA is optimal, and therefore coinciding with Eq. (13), Eq. (14) and Eq. (15) being simultaneously and approximately fulfilled for an integer $l_1$ for which $\omega_{p,opt}$ is closest to $\omega_{p,0}$.

To fulfill Eq. (13) for $l_1 \to l_1 + q$ in the same way as $\omega_{p,opt}$ does for $l_1$ the pump frequency shall be changed to

$$\omega_{p,opt,q} = \omega_{p,opt} + q\Delta\omega_p, \qquad (18)$$

$$\Delta\omega_p = \frac{2\pi}{\varphi_{D2,0}/\omega_{p,0} + \varphi_{T,0}/\omega_{p,0}} \qquad (19)$$

Since Eq. (13) is at least approximately fulfilled for $\omega_p = \omega_{p,opt}$ we have $\varphi_{D2,0}/\omega_{p,0} + \varphi_{T,0}/\omega_{p,0} \approx (2\pi l_1 - \varphi_J)/\omega_{p,opt}$ and thus

$$\Delta\omega_p = \frac{\omega_{p,opt}}{l_1 - \varphi_J/2\pi}. \qquad (20)$$

The same procedure applied to Eq. (14) yields a value

$$\Delta\widetilde{\omega}_p = \frac{\omega_{p,opt}}{l_1 - \left(\frac{\varphi_J + \pi}{2}\right)/2\pi}, \qquad (21)$$

i.e. $\omega_p + q\Delta\widetilde{\omega}_p$ fulfills Eq. (14) for $l_1 \to l_1 + q$ in the same way as $\omega_{p,opt}$ does for $l_1$. For large $l_1$, which is a realistic setting, we have $\Delta\omega_p \ll \Delta\widetilde{\omega}_p$ and we therefore expect to obtain optimal gain profiles for pump frequencies differing from $\omega_{p,opt}$ by multiples of a value close to $\Delta\omega_p$ and $\Delta\widetilde{\omega}_p$. It is worth mentioning that for the special case of only two TWPA sections, i.e. $N = 2$, we obtain optimal gain profiles at $\omega_p + q\Delta\widetilde{\omega}_p$.

Interferometric phase matching and the phase matching condition

Parametric amplification in a TWPA along its linear dimension x is conveniently described by coupled mode equations for the complex amplitudes $a_s(x)$ and $a_i(x)$ of the target signal and idler traveling waves,

$$\begin{aligned}\frac{da_s}{dx} &= i\kappa_s a_i^* e^{i\Delta kx}, \\ \frac{da_i}{dx} &= i\kappa_i a_s^* e^{i\Delta kx}.\end{aligned} \quad (22)$$

They are valid for slowly varying amplitudes $a_s(x)$ and $a_i(x)$ and if the total pump signal can be considered undepleted along the TWPA. The coefficients $\kappa_s, \kappa_i$ determine the amplification rate of the target signal and idler tones and have a quadratic (for four-wave mixing, 4WM) or linear (for three-wave mixing, 3WM) proportionality to the pump amplitude $a_p$, i.e.

$$\kappa_s, \kappa_i \propto \begin{cases} a_p^2 & \text{for 4WM} \\ a_p & \text{for 3WM} \end{cases} \quad (23)$$

To obtain efficient amplification in a TWPA, the phase mismatch between the total pump signal, target signal and idler modes,

$$\Delta\phi = \Delta kx, \quad (24)$$

shall be kept small as they propagate through the TWPA. The wavevector mismatch

$$\Delta k = \Delta k_C + \Delta k_K \quad (25)$$

has a chromatic contribution

$$\Delta k_C = \begin{cases} 2k_p - k_s - k_i & \text{for 4WM} \\ k_p - k_s - k_i & \text{for 3WM}, \end{cases} \quad (26)$$

and a Kerr contribution

$$\Delta k_K = \begin{cases} 2\alpha_p - \alpha_s - \alpha_i & \text{for 4WM} \\ \alpha_p - \alpha_s - \alpha_i & \text{for 3WM}. \end{cases} \quad (27)$$

Here, $\alpha_p$ is the self-Kerr coefficient and $\alpha_s, \alpha_i$ the cross-Kerr coefficients of the target signal and idler tones. It is important to note that for a fixed pump frequency $\omega_p$, $\Delta k$ is a function of the signal frequency $\omega_s$ (see also Eqs. (45)-(49) further below).

In the following, the symbol $\Delta k$ is used as a shorthand for $\Delta k(\omega_s = \omega_p)$ in a 4WM process and as a shorthand for $\Delta k(\omega_s = \omega_p/2)$ in a 3WM process, which correspond to the cases of degenerate target signal and idler frequencies $\omega_s = \omega_i$. From the context it should be clear when the frequency dependence needs to be considered. This is the case for example in the coupled mode equations.

For constant $\kappa_s, \kappa_i$, the coupled mode equations have an analytical solution (not shown). To describe interferometric phase matching, we account for the multiple sections $T_n$ of the TWPA by allowing $\kappa_s, \kappa_i$ and $\Delta k$ in Eq. (22) being piece-wise constant functions, i.e. these parameters may vary between sections. To obtain gain profiles we integrate the corresponding coupled mode equations numerically.

The two most widely adopted conventional phase matching techniques in TWPAs-resonant phase matching and periodic modulation of circuit parameters-directly act on the wavevector of the pump tone $k_p$. By engineering the dispersion $k(\omega)$ in the transmission line around the pump frequency $\omega_p$, $k_p$ may be sufficiently increased or decreased to obtain a small $\Delta k$ over a certain frequency range. However, typically according to conventional methods the TWPA transmission line is modulated or modified on a length scale small compared to a wavelength in the TWPA medium requiring a comparably complex and delicate tuning of device and operating parameters.

On the contrary, the technique according to the present invention modifies the transmission line on a length scale large compared to the wavelength. The reference length scale in this case is the coherence length

$$l_\mathrm{c} = \pi/\Delta k. \quad (28)$$

According to the present invention the phase is adjusted discretely and the phase adjustment is tunable at the design level.

Figure 4 shows a step-like increase of the phase of the total pump signal along the nonlinear transmission line and illustrates the concept of discrete phase mismatching. The phase mismatch $\Delta kx$ (dashed line) along the TWPA is approximately compensated by the phase adjustment $\Theta(x)$, resulting in a close-to-zero total phase mismatch (dash-dotted line) along the TWPA.

To approximately compensate the phase mismatch $\Delta\Phi(x)$, a step-like increase of the pump tone phase $\theta(x)$ in the TWPA line is realized with a step height $\varphi_J$ and a step width $x_J$. We note that this phase increase is on top of the dynamic phase and the Kerr phase. The resulting phase mismatch $\Delta\phi$ in the presence of the described phase adjustments (i.e., after at least partial compensation) is thus

$$\Delta\phi(x) = \Delta kx + \Theta(x), \quad (29)$$

with

$$\Theta(x) = \begin{cases} 2\theta(x) & \text{for } 4\mathrm{WM} \\ \theta(x) & \text{for } 3\mathrm{WM} \end{cases}. \quad (30)$$

To keep $\Delta\phi(x)$ close to zero along the TWPA transmission line (i.e., the phase mismatch being fully compensated), the step height of the function $\Theta(x)$,

$$\tilde{\varphi}_J = \begin{cases} 2\varphi_J & \text{for } 4\mathrm{WM} \\ \varphi_J & \text{for } 3\mathrm{WM} \end{cases} \quad (31)$$

and the step width $x_J$ shall obey the ratio

$$\frac{\tilde{\varphi}_J}{x_J} = -\Delta k \quad (32)$$

corresponding to the phase matching condition. The resulting at least partially compensated phase mismatch $\Delta\phi(x)$ of Eq. (29) when Eq. (32) is fulfilled is a saw-tooth-like function in Figure 4. The phase mismatch can be brought to zero at each interference point (discrete phase matching).

We note that it is desirable to keep the amplitude of the saw-tooth function also small along the nonlinear transmission line to ensure that all signal photons are generated with a similar phase. A small non-zero average phase mismatch along the nonlinear transmission line on the other hand does not matter greatly as it only changes the average phase of the generated signal photons. Therefore, with the proposed TWPA also a partial compensation of the average accumulated phase mismatch is sufficient to still achieve a high gain across a broad wavelength/frequency range (see discussions of gain profiles further below). For completeness we nevertheless mention that the average phase mismatch along the nonlinear transmission line can also be brought to zero by halving the first step width (full compensation on average).

Effective wavevector description

We now turn to an effective wavevector description of the phase matching process. We first note that due to the dependence of $\kappa_\mathrm{s}$, and $\kappa_\mathrm{i}$ on the total pump signal amplitude $a_\mathrm{P} \propto \mathrm{e}^{i\theta(x)}$, the coupled mode equations can be written as

$$\frac{da_\mathrm{s}}{dx} = i\kappa_{\mathrm{s},0} a_\mathrm{i}^* \mathrm{e}^{i\Delta kx} \mathrm{e}^{i\Theta(x)}, \quad (33)$$

and

$$\frac{da_i}{dx} = i\kappa_{i,0} a_s^* e^{i\Delta k x} e^{i\Theta(x)}, \qquad (34)$$

with $\kappa_{s,0} = \kappa_s / e^{i\Theta(x)}$ and $\kappa_{i,0} = \kappa_i / e^{i\Theta(x)}$. Hence, calculating the Fourier series of the function

$$f(x) \equiv e^{i\Theta(x)} = \sum_{n=-\infty}^{\infty} c_n e^{ik_n x}, \qquad (35)$$

allows us to treat the phase matching process in terms of effective wavevectors $k_n = 2\pi n/L$, where $L$ is the period of $f(x)$. The Fourier coefficients are calculated as

$$c_n = \frac{1}{L} \int_0^L f(x) e^{-ik_n x}\, dx. \qquad (36)$$

An explicit expression for $c_n$ can obtained but is rather lengthy and is therefore omitted. If $f(x)$ is realized in accordance with condition Eq. (32) we expect a large Fourier coefficient $c_{n_{PM}} = c_{PM}$ (PM=Phase matching) for the wavevector $k_{n_{PM}} = k_{PM} = -\Delta k$.

More precisely, in this case, the period $L = -2ml_c$ with a positive integer m and thus

$$k_{PM} = -\frac{n_{PM}}{m}\Delta k. \qquad (37)$$

Hence, $n_{PM} = m$. As an example, for $\tilde{\varphi}_J = 2\pi/3$ we have $n_{PM} = 1$.

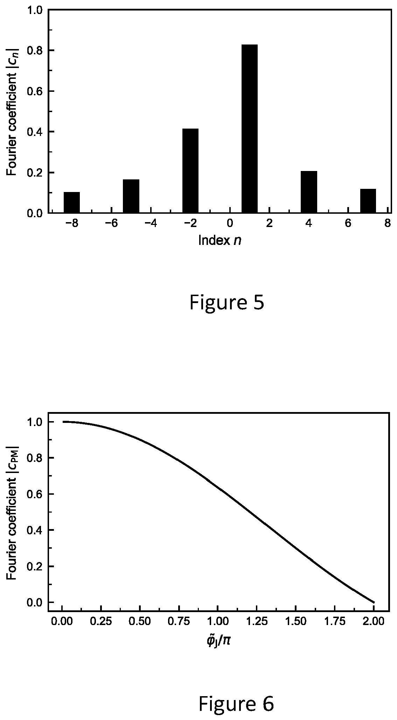

Figure 5 shows Fourier coefficients of the function $e^{i\Theta(x)}$ for a $\tilde{\varphi}_J = 2\pi/3$. The absolute values of the Fourier coefficients, $|c_n|$, are plotted in Figure 5 with a relatively large $|c_{PM}| \ll 0.83$. Figure 6 shows a modulus of the phase matching Fourier coefficient $c_{PM}$ as a function of $\varphi_J$, i.e., the functional dependence $|c_{PM}|$ vs. $\tilde{\varphi}_J$.

For dominant $c_{PM}$ we can turn to an effective description of the amplification process by neglecting the fast oscillating terms in the coupled mode equations,

$$\begin{aligned}\frac{da_s}{dx} &= i\kappa_{s,0} a_i^* e^{i\Delta k x} \sum_{n=-\infty}^{\infty} c_n e^{ik_n x} \approx i\kappa_{s,0} c_{PM} a_i^* e^{i(\Delta k + k_{PM})x}, \\ \frac{da_i}{dx} &= i\kappa_{i,0} a_s^* e^{i\Delta k x} \sum_{n=-\infty}^{\infty} c_n e^{ik_n x} \approx i\kappa_{i,0} c_{PM} a_s^* e^{i(\Delta k + k_{PM})x}.\end{aligned} \qquad (38)$$

From these equations it is evident that parametric amplification using the described discrete phase matching process can be effectively described by a perfect phase matching process with an amplification rate reduced by a factor $|c_{PM}|$. Furthermore, we note that we have kept the term $\Delta k + k_{PM}$ in the equations above because it is only zero for the symmetry point $\omega_s = \omega_i$, as mentioned above. Alternatively, we can engineer $k_{PM}$ slightly larger or smaller than $\Delta k$ at the symmetry point (depending on the sign of $\Delta k$) in order to achieve small $|\Delta k(\omega_s)|$ over a larger frequency band and thus a more uniform gain profile, at the expense of a reduced peak gain.

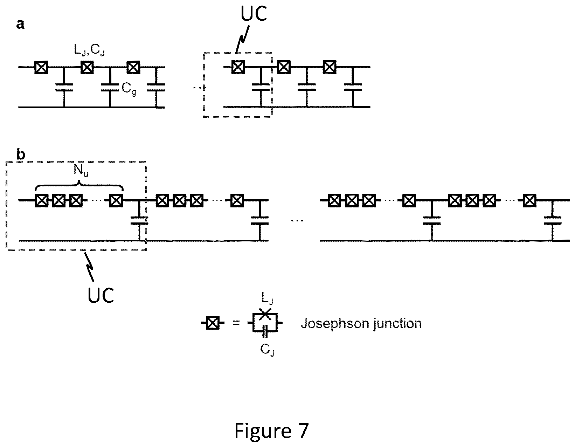

Figure 7 shows embodiments of the nonlinear transmission line. In particular, figure 7 shows an electric circuit diagram of a TWPA section for a nonlinear transmission line mediating a four-wave mixing process, 4WM, using Josephson junctions as a nonlinear medium. Panel (a) of figure 7 shows a single Josephson junction per unit cell UC. Panel (b) of figure 7 shows a linear array of $N_u$ Josephson junctions per unit cell UC. Each unit cell UC is a lumped element unit cell.

Configuration

The TWPA sections $T_n$ in this case are lumped element electronic transmission lines, with Josephson junctions coupled in series interleaved with capacitances $C_g$ to ground, see also Panel (a) in Fig. 7. The inductance $L(I)$ of a Josephson junction depends on the current $I$ flowing through it, providing the nonlinearity for the 4WM process,

$$L(I) = \frac{L_J}{\sqrt{1-(I/I_c)^2}}, \qquad (39)$$

with the critical current $I_c$ and the Josephson inductance

$$L_J = \frac{\phi_0}{2\pi I_c},\qquad (40)$$

where $\phi_0$ is the magnetic flux quantum. The Josephson junction also has a spurious capacitance $C_J$.

The TWPA is designed to have an impedance

$$\sqrt{\overline{L}/C_g} = 50\ \text{Ohm}$$

to match it to other microwave components. Here, $\overline{L}$ is the time-average inductance per unit cell, which is increased compared to $L_J$ in the presence of a strong pump tone, see Eq. (39).

To increase the dynamic range of the TWPA in another embodiment, while maintaining the same or a similar series inductance, one can replace a single Josephson junction in the nonlinear transmission line by a linear array of $N_u$ identical Josephson junctions, each with an increased critical current $\tilde{I}_c$, an inductance $\tilde{L}_J$ and a spurious capacitance $\tilde{C}_J$, see Panel (b) of Fig. 7 for a schematic.

A large series inductance is beneficial for achieving a slow phase velocity in the TWPA medium and thus a larger amplification rate. The Josephson junction array has an effective inductance $L_{J,eff} = N_u\tilde{L}_J$ per unit cell, and an effective series capacitance $\tilde{C}_{J,eff} = \tilde{C}_J/N_u$ per unit cell. As an example, if we increase the critical current by a factor $N_u$, i.e. $\tilde{I}_c = N_u I_c$ by increasing the junction area by a factor $N_u$ compared to a Josephson junction with parameters ($I_c$, $L_J$, $C_J$), we obtain $L_{J,eff} = N_u\tilde{L}_J = L_J$ and $C_{J,eff} = \tilde{C}_J/N_u = C_J$. Hence, the effective parameters of such a junction array are ($N_u$ $I_c$, $L_J$, $C_J$) and, correspondingly, the dynamic range of the amplifier is increased by a factor $20\log(N_u)$ dB if the dynamic range is limited by pump power depletion. We note that the subsequent equations apply to both, a single Josephson junction per unit cell and an array of Josephson junctions per unit cell.

TWPA equations

The lumped elements building the unit cell of the nonlinear transmission line define two frequencies, a characteristic frequency $\omega_0 = 1/\sqrt{L_J C_g}$, which is half the Bragg frequency above which transmission stops, and the plasma frequency of the Josephson junction, $\omega_J = 1/\sqrt{L_J C_J}$, which introduces a nonlinearity in the dispersion relation $k(\omega)$ of the nonlinear transmission line.

In the weakly nonlinear limit, wave propagation in such a nonlinear transmission line can be described by a nonlinear continuous wave equation in the node flux $\phi(x, t)$ along the transmission line,

$$\frac{1}{\omega_0^2}\frac{\partial^2\phi}{\partial t^2} - \frac{\partial^2\phi}{\partial x^2} - \frac{1}{\omega_J^2}\frac{\partial^4\phi}{\partial x^2\partial t^2} = \left(\frac{2\pi}{\phi_0}\right)^2\frac{\partial^2\phi}{\partial x^2}\left(\frac{\partial\phi}{\partial x}\right)^2.\qquad (41)$$

Here, a dimensionless coordinate x is used, which has units of unit cell lengths. Applied to a 4WM TWPA, we look for solutions for the total pump signal, target signal and idler waves, under the constraint $\omega_s + \omega_i = 2\omega_p$. Under the slowly varying amplitude approximation and the undepleted pump approximation the solutions for the pump, signal and idler node flux waves are of the form

$$\phi_p(x, t) = \frac{1}{2}\left[A_{p,0}e^{i\theta(x)}e^{i\alpha_p x}e^{i(k_p x + \omega_p t)} + c.c.\right],\qquad (42)$$

$$\phi_s(x, t) = \frac{1}{2}\left[a_s(x)e^{i\alpha_s x}e^{i(k_s x + \omega_s t)} + c.c.\right],\qquad (43)$$

$$\phi_i(x, t) = \frac{1}{2}\left[a_i(x)e^{i\alpha_i x}e^{i(k_i x + \omega_i t)} + c.c.\right],\qquad (44)$$

with the angular frequency $\omega_m$ (m = p, s, i) and the dimensionless wavevector

$$k_m = \frac{\omega_m/\omega_0}{\sqrt{1-(\omega_m/\omega_J^2)^2}}, \quad (45)$$

which has units of one over the unit cell length. The self-Kerr coefficient $\alpha_p$ and the cross-Kerr coefficients $\alpha_{s,i}$ describe self-phase and cross-phase modulation of the waves, respectively, and are given by

$$\alpha_p = k_p^3 \left(\frac{\omega_0}{\omega_p}\right)^2 |\kappa| \quad (46)$$

$$\alpha_s = 2k_s^3 \left(\frac{\omega_0}{\omega_s}\right)^2 |\kappa| \quad (47)$$

$$\alpha_i = 2k_i^3 \left(\frac{\omega_0}{\omega_i}\right)^2 |\kappa| \quad (48)$$

$$\kappa = \frac{1}{16} k_p^2 \left(\frac{\omega_0}{\omega_p}\right)^2 \left(\frac{I_p}{I_c}\right)^2 e^{2i\theta(x)} \quad (49)$$

It is noted that we have fixed the modulus of the amplitude of the pump wave of the total pump signal to the same value $A_{p,0}$ for all TWPA sections and only allow for a position-dependent phase update $e^{\theta(x)}$ which is a piece-wise constant function in the proposed interferometric phase matching technique as described above. For completeness we note that x does not include the length of the directional couplers. The amplitudes $a_s(x)$ and $a_i(x)$ of the target signal and idler waves are obtained from solving the coupled amplitude equations

$$\frac{da_s}{dx} = i\kappa_s a_i^* e^{i\Delta kx}, \quad (50)$$

$$\frac{da_i}{dx} = i\kappa_i a_s^* e^{i\Delta kx}, \quad (51)$$

with

$$\kappa_s = (2k_p - k_i)k_s k_i \left(\frac{\omega_0}{\omega_p}\right)^2 \kappa \quad (52)$$

$$\kappa_i = (2k_p - k_s)k_i k_s \left(\frac{\omega_0}{\omega_p}\right)^2 \kappa \quad (53)$$

and the total wave vector mismatch

$$\Delta k = 2k_p - k_s - k_i + 2\alpha_p - \alpha_s - \alpha_i, \quad (54)$$

which has a chromatic contribution $\Delta k_c = 2k_p - k_s - k_i$ due to dispersion in the nonlinear transmission line and a Kerr contribution $\Delta k_K = 2\alpha_p - \alpha_s - \alpha_i$ due to self- and cross-phase modulation mediated by the nonlinearity of the nonlinear transmission line.

Gain profiles

In most applications a TWPA is followed by a high-electron-mobility-transistor (HEMT) amplifier operated at a temperature of about 4 K, which have a noise temperature typically a factor 10-20 larger than the quantum limit. Hence, to overcome the HEMT noise, i.e. ensuring that the noise of the amplification chain is not limited by the HEMT noise, it is desirable for a quantum noise-limited TWPA to have a gain of about 20 dB.

We now calculate the signal gain at the output of the TWPA,

$$G = 20\log(a_s(L)) \quad (55)$$

by numeric integration of the coupled amplitude equations with the initial conditions $a_s(0) = 1$ and $a_i(0) = 0$. Here, L is the total length of the TWPA in units of unit cell lengths. It corresponds to the number of Josephson junctions for the nonlinear transmission line shown in Panel (a) of Figure 7.

Quadruple-section TWPA

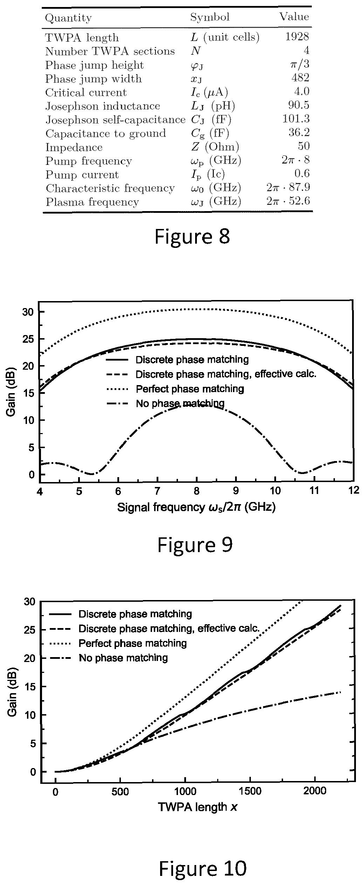

Figure 8 shows a parameter table for a traveling wave parametric amplifier with four coupling elements, i.e., these parameters are used to calculate the gain profile for a TWPA with four directional couplers and four TWPA segments, i.e., a so-called quadruple-section TWPA.

Figure 9 shows gain profiles for a traveling wave parametric amplifier with four coupling elements, i.e., gain profiles of the quadrupole-section TWPA with parameters as specified in Figure 8.

For $N = 4$ identical TWPA sections, $\varphi_J = \pi/3$ and $x_J = 2\varphi_J/\Delta k \approx 482$, a total of 1928 Josephson junctions, and the parameters listed in the Table of Figure 8 we obtain the gain profile shown in Figure 9 as a solid line. We achieve a gain in excess of 20 dB and a 3dB bandwidth of about 5 GHz. The gain profile calculated using the effective coupled amplitude equations Eq. (38) is a very good approximation in this case. For comparison, we plot the gain profiles achieved with the same number of Josephson junctions for perfect phase matching (dotted line) and for no phase matching at all (dash-dotted line). The chosen pump current amplitude $I_p = 0.6\,I_c$ is a typical optimistic value for the maximum pump current that can be applied in a practical setting.

Figure 10 shows the gain as a function of the distance for a traveling wave parametric amplifier with four coupling elements, i.e., the gain as a function of the length/distance x in a quadruple-section TWPA with the parameters of Figure 8.

To get further insight in the amplification process we calculate the gain as a function of the position $x$ in the TWPA, i.e. $G(x) = 20\log(a_s(x))$, for a fixed target signal frequency of $\omega_s/2\pi = \omega p/2\pi = 8$ GHz. We clearly observe the increased slope at the positions x = 482, 964, 1446 at which the phase of the total pump signal is adjusted in Figure 10. Again, the effective calculation reproduces the exact numerical result very well. The necessity of phase matching becomes obvious when calculating G(x) for the case of no phase matching (dash-dotted line): The increase in gain levels off after about a coherence length, which is 724 unit cells in our example.

Double-section TWPA

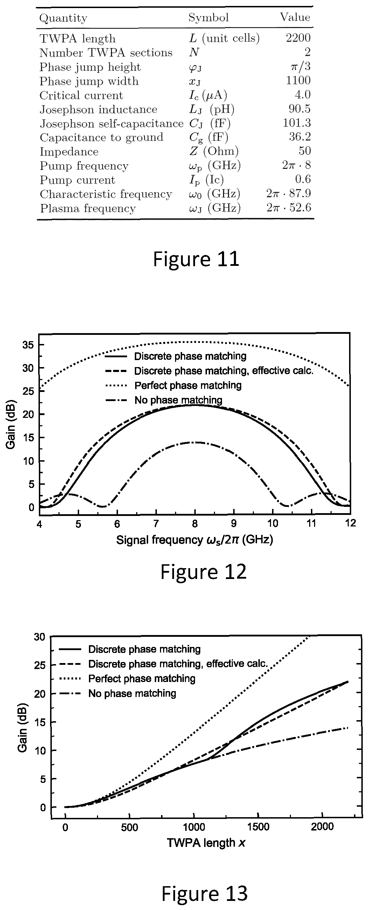

Figure 11 shows a parameter table for a traveling wave parametric amplifier with two coupling elements, i.e., these parameters are used to calculate the gain profile for a TWPA with two directional couplers and two TWPA segments, i.e., a so-called double-section TWPA.

Figure 12 shows gain profiles for a traveling wave parametric amplifier with two coupling elements, i.e., gain profiles of the double-section TWPA with parameters as specified in Figure 11.

Further above, we discussed some advantage of a TWPA with only two sections. Using the same Josephson junction circuit parameters as for the quadruple-section TWPA, we find that we can obtain a gain in excess of 20 dB and a 3dB bandwidth of about 3 GHz using only 2200 Josephson junctions, see Figure 12. We note that in this case the effective wavevector $k_1 = 2\varphi_J/x_J$ is smaller than $|\Delta k|$ due to the large section length of 1100 unit cells, hence $k_1 + \Delta k$ is finite even at the pump frequency. Again, the effective calculation reproduces the exact numerical result well. The parameters used for the simulation of this double-section TWPA device are summarized in Figure 11.

Figure 13 shows the gain as a function of the distance for a traveling wave parametric amplifier with two coupling elements, i.e., the gain as a function of the length/distance x in a double-section TWPA with the parameters of Figure 11.

The gain as a function of the position/distance x in the double-section TWPA is shown in Figure 13 for $\omega_s/2\pi = \omega_p/2\pi = 8$ GHz. Compared to the quadruple-section TWPA the gain increase saturates more towards the end of the first section of the nonlinear transmission line. The effective calculation using Eq. (38) and the cases of perfect phase matching and no phase matching at all are shown for comparison. We emphasize the large effect of the phase adjustment at x = 1100 compared to the case of no phase matching.

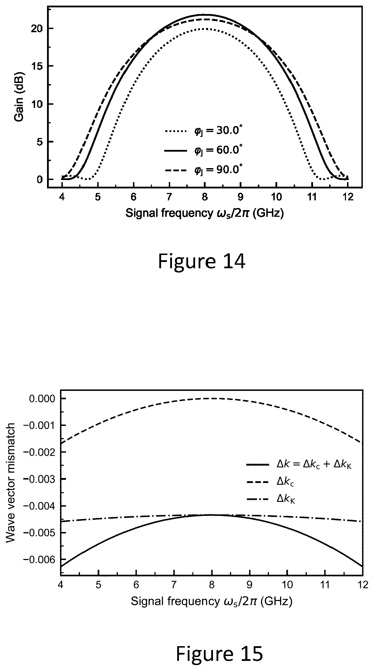

Figure 14 shows gain profiles for different step heights for a traveling wave parametric amplifier with two coupling elements, i.e., gain profiles of a double-section TWPA for varying $\varphi_J$, but otherwise the same parameters as listed in Figure 11.

As pointed out previously the coupling factor of the second directional coupler DC2 relative to the coupling factor of the first directional coupler DC1 fixes $\varphi_J$ assuming we experimentally set the pump frequency such that the pump current amplitudes of both sections are equal. To show the large insensitivity with respect to the realized $\varphi_J$ in that case we compute the gain profiles for $\varphi_J = \pi/6, \pi/3, \pi/2$ for otherwise the same parameters as listed in Figure 11. All three values of $\varphi_J$ achieve a maximum gain close to 20 dB, with the 3dB bandwidth slightly increasing when going from $\varphi_J = \pi/6$ to $\pi/2$.

We now demonstrate the possibility to operate the TWPA at different pump frequencies. The phase velocity (in units of unit cells per second) in a TWPA sections is

$$v_{\mathrm{ph}} = \omega/k = \omega_0\sqrt{1 - (\omega/\omega_J)^2} \approx \omega_0 \qquad (56)$$

The wavelength (in units of unit cells) in a TWPA section is $\lambda = 2\pi \cdot \omega_0/\omega$. In particular, the wavelength at $\omega = \omega_p = 2\pi \cdot 8$ GHz for the parameters listed in Figure 8 is $\lambda_p = 69$. Hence for the quadruple-section TWPA the electrical length of a single TWPA section is about $\approx 2\pi \cdot x_J/\lambda_p \approx 2\pi \cdot 7$. The previously defined electrical length $\varphi_T$ is slightly larger because it includes the direction coupler (adding $\pi/2$ for a $\lambda/4$ directional coupler) and any (possible) linear transmission line section inside the TWPA sections used e.g. to connect to the directional couplers (which are still considered part of the nonlinear transmission line).

Assuming $\varphi_D \sim 2\pi$ we obtain $\Delta\omega_p \sim \omega_{p,opt}/8 = 1$ GHz for the discussed parameters. For the double-section TWPA $x_J$ is by more than a factor two larger, and we thus have $\Delta\omega_p \sim 0.5$ GHz in that case. We emphasize that having the possibility to center the gain profile on a grid with a spacing $\Delta\omega_p$ can be of high practical relevance.

Figure 15 shows the wavevector mismatch. The wavevector mismatch $\Delta k$ is a function of the target signal frequency $\omega_s$. We plot $\Delta k(\omega_s)$ together with its constituents $\Delta k_C$ and $\Delta k_K$ in Figure 15 for a quadrupole-section TWPA based on Josephson junctions, using the parameters listed in Figure 8. We see that while $\Delta k_K$ causes the offset from zero, $\Delta k_C$ is mainly responsible for the frequency dependence. We note that $\Delta k$ is typically positive for a three-wave mixing TWPA with the dominant contribution being $\Delta k_C$.

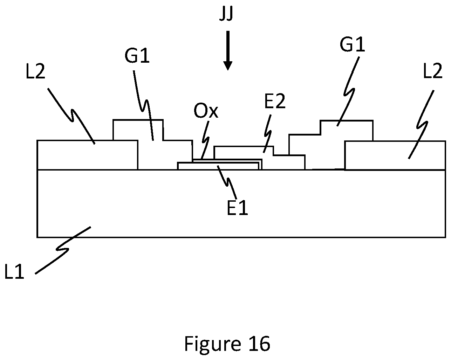

Figure 16 shows an embodiment of a Josephson junction JJ as implemented in an embodiment of a TWPA as a cross section. The TWPA comprises the substrate L1, a patterned first metal layer L2 directly on the substrate L1 and a Josephson junctions JJ directly on the substrate L1. The patterned first metal layer L2 comprises first metal pads L2. The Josephson junction JJ is arranged in a gap between two first metal pads L2. Galvanic connections G1 overlap and couple the Josephson junction JJ with the first metal pads L2. The galvanic connections G1 are arranged to overlap the first metal pads L2, the substrate L1 and the Josephson junction JJ. The Josephson junction JJ comprises a second metal pad E1 (electrode) directly on the substrate L1, an oxide layer Ox directly on the second metal pad E1 and a third metal pad E2 (electrode) directly on the oxide layer Ox. More specifically, a first galvanic connection G1 is directly on the second metal pad E1, the substrate L1 and one of the first metal pads L2. A second galvanic connection G1 is directly on the third metal pad E2, the substrate L1 and another one of the first metal pads L2.

The substrate L1 is a Silicon substrate. The metal pads L2 are made from Niobium. The second E1 and third E2 metal pad are made from Aluminum. The oxide layer Ox is an aluminum oxide layer. The galvanic connections G1 are made from Aluminum as well.

The TWPA structure shown in Figure 16 is manufactured using the following steps:

- forming the first metal layer L2 over and on the substrate L1;

- patterning the first metal layer L2; and

- forming the Josephson junctions JJ over and on the substrate L1.

The patterning of the first metal layer L2 includes etching the first metal layer to form the first metal pads L2 and a gap in between for forming the Josephson junction JJ (i.e., the forming of the Josephson junction JJ in the gap is performed in a later step after the patterning of the first metal layer L2). The patterning of the first metal layer L2 also comprise etching gaps between the first metal pads L2 and ground metal plates for forming capacitances to ground (not shown). The ground metal plates are also made of Niobium and part of the first metal layer L2.

The forming of the Josephson junction JJ includes forming the second metal pad E1 on the substrate L1 to form a first electrode, forming the oxide layer Ox on the second metal pad E1 and forming the third metal pad E2 on the oxide layer Ox and on the substrate L1.

The method also comprises forming the galvanic connections G1 on the first metal pads L2, the substrate L1 and the Josephson junction JJ for coupling the Josephson junction JJ and the first metal pads L2.

Features of the different embodiments which are merely disclosed in the exemplary embodiments as a matter of course can be combined with one another and can also be claimed individually.

**Claims**

1. Traveling wave parametric amplifier for amplifying a target signal, the traveling wave parametric amplifier comprising:

a nonlinear transmission line (T1, T2) for receiving and propagating the target signal;
a plurality of coupling elements (DC1, DC2), wherein the plurality of coupling elements (DC1, DC2) are arranged at a distance from one another along the nonlinear transmission line (T1, T2); and each coupling element of the plurality of coupling elements (DC1, DC2) is configured to couple a pump signal portion from a pump feed line (D1) into the nonlinear transmission line (T1, T2), wherein the coupled-in pump signal portions form a total pump signal co-propagating in the nonlinear transmission line (T1, T2) in the same direction as the target signal for amplifying the target signal, and
the nonlinear transmission line (T1, T2) and the plurality of coupling elements (DC1, DC2) are further configured to bring the coupled-in pump signal portions into interference with respect to each other along the nonlinear transmission line (T1, T2), wherein through the interference a phase mismatch between the total pump signal, the target signal and its idler accumulated while co-propagating in the non-linear transmission line (T1, T2) is being compensated at least partially.

2. Traveling wave parametric amplifier according to claim 1, wherein the phases and/or power of the coupled-in pump signal portions are configured to induce at least one phase jump of the phase of the total pump signal at an interference point ($IP_1$) along the nonlinear transmission line (T1, T2) leading to a step-like increase of the phase of the total pump signal.

3. Traveling wave parametric amplifier according to one of the preceding claims, wherein the nonlinearity of the nonlinear transmission line (T1, T2) corresponds to a three-wave mixing process or a four-wave mixing process.

4. Traveling wave parametric amplifier according to one of the preceding claims, wherein the phases and/or power of the coupled-in pump signal portions are configured such that a power loss of the total pump signal accumulated while propagating in the nonlinear transmission line (T1, T2) is being compensated at least partially through the interference.

5. Traveling wave parametric amplifier according to one of the preceding claims, wherein the nonlinear transmission line (T1, T2) comprises a high kinetic inductance material and/or a plurality of Josephson junctions coupled in series to mediate a nonlinearity that converts power from the total pump signal into the target signal and its idler during amplification.

6. Traveling wave parametric amplifier according to one of the preceding claims, wherein each of the plurality of coupling elements (DC1, DC2) is a directional coupler, wherein the directional coupler of the plurality of coupling elements (DC1, DC2) are connected in series by the nonlinear transmission line (T1, T2).

7. Traveling wave parametric amplifier according to claim 6, wherein the length of each segment of the nonlinear transmission line connecting two directional coupler (DC1, DC2) corresponds to at least a few wavelengths of the target signal and/or the pump signal portions.

8. Traveling wave parametric amplifier according to one of the preceding claims, wherein the plurality of coupling elements (DC1, DC2) are connected in series by the pump feed line (D1), wherein the pump feed line (D1) is a linear transmission line configured to receive and propagate a pump tone, wherein the coupled-in pump signal portions are portions of the pump tone and/or wherein the pump tone, the coupled-in pump signal portions and the total pump signal have the same pump frequency.

9. Traveling wave parametric amplifier according to one of the preceding claims, wherein the plurality of coupling elements (DC1, DC2) comprise more than two coupling elements connected in series by segments of the nonlinear transmission line (T1, T2), wherein the lengths and/or

the electrical lengths of the connecting segments of the nonlinear transmission line (T1, T2) are the same; and/or

the plurality of coupling elements (DC1, DC2) comprise more than two coupling elements connected in series by segments of the pump feed line (D1, D2), wherein the lengths and/or the electrical lengths of at least two of the connecting segments of the pump feed line (D1, D2) are different.

10. Traveling wave parametric amplifier according to one of the preceding claims, wherein the nonlinear transmission line (T1, T2), the pump feed line (D1) and the plurality of coupling elements (DC1, DC2) are co-integrated on-chip.

11. Traveling wave parametric amplifier according to any of the preceding claims comprising an additional coupling element arranged after the plurality of coupling elements (DC1, DC2) along the nonlinear transmission line (T1, T2) in the propagation direction of the target signal, wherein the additional coupling element is configured to bring an additional pump signal portion from the pump feed line into destructive interference with the total pump signal coming from the nonlinear transmission line (T1, T2).

12. Method of manufacturing a traveling wave parametric amplifier according to any one of the preceding claims 1 to 11, wherein the non-linear transmission line (T1, T2) comprises Josephson junctions coupled in series and the method comprises

forming a first metal layer (L2) over a substrate (L1)
patterning the first metal layer (L2), and
forming the Josephson junctions (JJ) over the substrate (L1) and/or over the patterned first metal layer (L2).

13. Method for amplifying a target signal, the method comprising:

receiving and propagating, by a nonlinear transmission line (T1, T2), the target signal; and
coupling, by each coupling element of a plurality of coupling elements (DC1, DC2), a pump signal portion from a pump feed line (D1) into the nonlinear transmission line (T1, T2), the coupled-in pump signal portions forming a total pump signal co-propagating in the nonlinear transmission line (T1, T2) in the same direction as the target signal for amplifying the target signal, wherein the plurality of coupling elements (DC1, DC2) are arranged at a distance from one another along the non-linear transmission line (T1, T2); and
bringing the coupled-in pump signal portions into interference with respect to each other in the nonlinear transmission line (T1, T2); and
configuring the nonlinear transmission line (T1, T2) and the plurality of coupling elements (DC1, DC2) such that a phase mismatch between the total pump tone, the target signal and its idler accumulated while co-propagating in the nonlinear transmission line (T1, T2) is being compensated at least partially through the interference.

14. A computer program comprising instructions which, when the program is executed by a computer, cause the computer using a traveling wave parametric amplifier, to carry out the steps of the method according to to claim 13.

15. A computer-readable data carrier having stored thereon the computer program of claim 14.

Figure 1

EP 4 625 816 A1

Figure 2

Figure 3

Figure 4

Figure 5

Figure 6

Figure 7

| Quantity | Symbol | Value |
|---|---|---|
| TWPA length | $L$ (unit cells) | 1928 |
| Number TWPA sections | $N$ | 4 |
| Phase jump height | $\varphi_J$ | $\pi/3$ |
| Phase jump width | $x_J$ | 482 |
| Critical current | $I_c$ ($\mu$A) | 4.0 |
| Josephson inductance | $L_J$ (pH) | 90.5 |
| Josephson self-capacitance | $C_J$ (fF) | 101.3 |
| Capacitance to ground | $C_g$ (fF) | 36.2 |
| Impedance | $Z$ (Ohm) | 50 |
| Pump frequency | $\omega_p$ (GHz) | $2\pi \cdot 8$ |
| Pump current | $I_p$ (Ic) | 0.6 |
| Characteristic frequency | $\omega_0$ (GHz) | $2\pi \cdot 87.9$ |
| Plasma frequency | $\omega_J$ (GHz) | $2\pi \cdot 52.6$ |

# Figure 8

# Figure 9

# Figure 10

| Quantity | Symbol | Value |
|---|---|---|
| TWPA length | $L$ (unit cells) | 2200 |
| Number TWPA sections | $N$ | 2 |
| Phase jump height | $\varphi_J$ | $\pi/3$ |
| Phase jump width | $x_J$ | 1100 |
| Critical current | $I_c$ ($\mu$A) | 4.0 |
| Josephson inductance | $L_J$ (pH) | 90.5 |
| Josephson self-capacitance | $C_J$ (fF) | 101.3 |
| Capacitance to ground | $C_g$ (fF) | 36.2 |
| Impedance | $Z$ (Ohm) | 50 |
| Pump frequency | $\omega_p$ (GHz) | $2\pi \cdot 8$ |
| Pump current | $I_p$ (Ic) | 0.6 |
| Characteristic frequency | $\omega_0$ (GHz) | $2\pi \cdot 87.9$ |
| Plasma frequency | $\omega_J$ (GHz) | $2\pi \cdot 52.6$ |

## Figure 11

Figure 12

Figure 13

Figure 14

Figure 15

Figure 16

Europäisches
Patentamt

European
Patent Office

Office européen
des brevets

# EUROPEAN SEARCH REPORT

**Application Number**

EP 24 16 6897

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SONGYUAN ZHAO ET AL: "Loss and saturation in superconducting travelling-wave parametric amplifiers", JOURNAL OF PHYSICS D: APPLIED PHYSICS, INSTITUTE OF PHYSICS PUBLISHING, BRISTOL, GB, vol. 52, no. 41, 29 July 2019 (2019-07-29), page 415301, XP020343776, ISSN: 0022-3727, DOI: 10.1088/1361-6463/AB3236 [retrieved on 2019-07-29] * page 4, left-hand column, line 23 - right-hand column, line 2; figure 1 * * page 6, left-hand column, lines 10-19; figure 7 * | 1-15 | INV. H03F7/00 H03F19/00 |
| A | ZORIN A B: "Flux-driven Josephson traveling-wave parametric amplifier", ARXIV.ORG, CORNELL UNIVERSITY LIBRARY, 201 OLIN LIBRARY CORNELL UNIVERSITY ITHACA, NY 14853, 24 April 2018 (2018-04-24), XP081554274, DOI: 10.1103/PHYSREVAPPLIED.12.044051 * abstract; figure 1 * | 1-15 | |
| A | US 3 012 203 A (KING TIEN PING) 5 December 1961 (1961-12-05) * column 3, line 76 - column 14, line 61; figures 1,2 * * column 17, line 75 - column 18, line 4 * | 1-15 | TECHNICAL FIELDS SEARCHED (IPC) H03F |
| A | US 2013/207725 A1 (AFSHARI EHSAN [US] ET AL) 15 August 2013 (2013-08-15) * paragraphs [0049] - [0051]; figures 1,3 * | 1-15 | |

The present search report has been drawn up for all claims

| Place of search | Date of completion of the search | Examiner |
|---|---|---|
| The Hague | 16 August 2024 | Zakharian, Andre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 6897

This annex lists the patent family members relating to the patent documents cited in  the above-mentioned European search report.
The members are as contained in the European Patent Office EDP file on
The European Patent Office is in no way liable for these particulars which are merely given for the purpose of information.

16-08-2024

| Patent document cited in search report | | Publication date | Patent family member(s) | | Publication date |
|---|---|---|---|---|---|
| US 3012203 | A | 05-12-1961 | NONE | | |
| US 2013207725 | A1 | 15-08-2013 | US | 2013207725 A1 | 15-08-2013 |
| | | | WO | 2011156379 A2 | 15-12-2011 |

EPO FORM P0459

For more details about this annex : see Official Journal of the European Patent Office, No. 12/82